(19) **Europäisches Patentamt / European Patent Office / Office européen des brevets**

(11) **EP 3 262 707 B1**

(12) # FASCICULE DE BREVET EUROPEEN

(45) Date de publication et mention de la délivrance du brevet:
**27.03.2019 Bulletin 2019/13**

(21) Numéro de dépôt: **16707065.5**

(22) Date de dépôt: **24.02.2016**

(51) Int Cl.:
*H01P 7/08* (2006.01)  *G02B 1/00* (2006.01)
*H01P 11/00* (2006.01)  *H01L 49/02* (2006.01)
*H01P 1/203* (2006.01)  *H01Q 15/00* (2006.01)
*H01P 5/02* (2006.01)  *H01P 1/20* (2006.01)

(86) Numéro de dépôt international:
**PCT/EP2016/053890**

(87) Numéro de publication internationale:
**WO 2016/135208 (01.09.2016 Gazette 2016/35)**

(54) **DISPOSITIF RESONATEUR ELECTRIQUE TRIDIMENSIONNEL DE TYPE INDUCTANCE-CAPACITE**

DREIDIMENSIONALE ELEKTRISCHE LC-RESONATORVORRICHTUNG

THREE-DIMENSIONAL LC ELECTRICAL RESONATOR DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.02.2015 FR 1551581**

(43) Date de publication de la demande:
**03.01.2018 Bulletin 2018/01**

(73) Titulaires:
• **Université Paris Diderot - Paris 7**
  **75013 Paris (FR)**
• **Centre National de la Recherche Scientifique CNRS**
  **75796 Paris 16 (FR)**

(72) Inventeurs:
• **DESFONDS, Pascal**
  **92100 Boulogne-Billancourt (FR)**
• **TODOROV, Yanko**
  **75013 Paris (FR)**
• **SIRTORI, Carlo**
  **75014 Paris (FR)**

(74) Mandataire: **Regimbeau**
  **20, rue de Chazelles**
  **75847 Paris Cedex 17 (FR)**

(56) Documents cités:
WO-A1-2014/072335  JP-A- 2007 273 832
US-A1- 2008 296 710  US-A1- 2010 117 765

**Description**

**DOMAINE TECHNIQUE**

L'invention concerne un dispositif résonateur électrique tridimensionnel de type inductance-capacité pour les hautes fréquences (≥100 GHz).

**ETAT DE LA TECHNIQUE**

On connait des résonateurs de type « split-ring » comprenant une piste métallique sous la forme d'un anneau ouvert. Ces résonateurs de dimensions micrométriques se comportent comme des résonateurs électriques de type LC (inductance-capacité). La partie en forme de boucle de la piste métallique constitue l'inductance L. La partie en forme de boucle s'étend entre deux extrémités situées en regard l'une de l'autre et formant la capacité C.

Ces résonateurs sont utilisés notamment pour la fabrication de métamatériaux, c'est-à-dire des matériaux présentant des propriétés électromagnétiques qui ne se retrouvent pas dans un matériau naturel, telles que des matériaux présentant un indice de réfraction négatif par exemple à une fréquence de résonance donnée.

Cependant, ces résonateurs de type split-ring présentent généralement une faible capacité de couplage avec le substrat semi-conducteur sur lequel est formé le résonateur.

En effet, le champ électrique généré dans la zone capacitive (entre les extrémités de la boucle) s'étend principalement selon une direction parallèle à la surface du substrat. Le champ électrique généré dans la zone capacitive est donc perpendiculaire au champ magnétique généré par la boucle, ce qui favorise les effets de propagations. De plus, seulement une fraction du champ électrique généré dans la zone capacitive, correspondant à un champ électrique de fuite n'est couplé avec le substrat semi-conducteur.

B. Paulillo et al « Circuit-tunable sub-wavelength THz resonators : hybridizing optical cavities and loop antennas », Optics Express, 8 septembre 2014, vol. 22, no.18, décrit un dispositif résonateur comprenant deux couches métalliques disposées en regard l'un de l'autre, et une antenne boucle reliant les deux couches métalliques. Les deux couches métalliques forment une zone capacitive, et l'antenne boucle forme une zone inductive, de sorte que le dispositif résonateur se comporte comme un circuit LC. L'antenne boucle est formée d'une métallisation suspendue qui peut être fabriquée par un procédé de micro-usinage couramment utilisé pour fabriquer des structures de pont d'air. La fréquence de résonance du dispositif résonateur peut être ajustée en modifiant les paramètres géométriques de l'antenne boucle ou des couches métalliques. La zone capacitive peut accueillir un matériau actif, pouvant être un émetteur (par exemple un laser à cascade quantique monopolaire- QC), un détecteur (un détecteur infrarouge à puits quantique - QWIP), ou un absorbeur (un puits quantique pour des applications polaritoniques par exemple).

Le dispositif résonateur proposé dans ce document présente l'avantage que le champ électrique généré par la zone capacitive est localisé principalement dans le matériau actif, ce qui améliore le couplage du dispositif résonateur avec le matériau actif.

Cependant, le champ électrique généré dans la zone capacitive est perpendiculaire au champ magnétique généré par l'antenne boucle, ce qui ne permet pas d'exclure les effets de propagations.

En outre, il n'est pas possible de raccorder de manière simple le dispositif à un générateur de courant ou à un détecteur de courant afin de détecter un courant extrait à partir du dispositif.

Le document JP2007273832 divulgue un dispositif résonateur tridimensionnel de type LC sensible aux signaux lumineux incidents.

Le document WO2014072335 divulgue un dispositif de micro-ondes pour le couplage capacitif entre deux lignes micro-ruban.

Le document US2008296710 divulgue des résonateurs de type split-ring.

**RESUME DE L'INVENTION**

Un but de l'invention est de proposer un dispositif résonateur capable de fonctionner dans les hautes fréquences (supérieures ou égales à 100 GigaHz) présentant des capacités de couplage améliorées.

Un autre but de l'invention est de proposer un dispositif résonateur permettant un raccordement aisé avec un générateur de courant ou avec un détecteur de courant.

Ce but est atteint dans le cadre de la présente invention grâce à un dispositif résonateur selon la revendication 1.

Avec un tel dispositif, le champ magnétique généré par la boucle inductive dans la couche séparatrice présente une composante principale s'étendant selon une direction parallèle au champ électrique généré par les capacités. En d'autres termes, dans la couche séparatrice la projection du champ H dans la direction du champ électrique E est supérieure en valeur absolue aux autres projections du champ H.

Cette caractéristique permet d'exclure les phénomènes de propagation. Il s'ensuit que le dispositif résonateur fonctionne en régime quasi-statique. Dans un tel régime, les dimensions du résonateur peuvent être très petites par rapport à la longueur d'onde de résonance du dispositif.

Dans un « régime quasi-statique », la source du champ magnétique est essentiellement le courant qui circule dans les pistes en matériau conducteur, et non pas les variations du champ électrique dans le temps, encore connu comme « courant de déplacement ».

Pour obtenir un régime quasi-statique, la taille du résonateur doit être plus petite que la longueur d'onde de résonance. Par ailleurs, pour une géométrie donnée, les modes quasi-statiques sont favorisés si, par la conception de la structures, les champs E et H sont contraintes d'être parallèles et/ou d'être localisés dans des volumes différents.

Par ailleurs, dans un tel dispositif résonateur, les deux pistes peuvent être raccordées facilement à un générateur de courant ou un détecteur de courant.

Le champ électrique généré par chaque capacité s'étend selon une direction parallèle à la direction de l'épaisseur de la couche séparatrice, ce qui permet d'intégrer dans la couche séparatrice un matériau actif.

L'inductance et la capacité du dispositif peuvent être ajustées indépendamment l'une de l'autre de manière à obtenir la fréquence de résonance désirée. En particulier, il est possible de réduire les dimensions des parties de chevauchement, de manière à concentrer le champ électrique dans des zones de la couche séparatrice de faibles dimensions, ce qui conduit à l'obtention d'un champ électrique de forte intensité dans ces zones.

Le dispositif résonateur peut en outre présenter les caractéristiques suivantes :

- l'hétérostructure quantique comprend un empilement de couches d'un premier matériau semi-conducteur et d'un deuxième matériau semi-conducteur, différent du premier matériau, disposées en alternance, chaque couche de l'empilement s'étendant perpendiculairement à la direction de l'épaisseur de la couche séparatrice,

- le premier et le deuxième matériau sont choisis parmi : GaAs et $Ga_{1-x}Al_xAs$, GaAs et AlGaAs, InAs et AlSb, GaN, et AlGaN, GaN et InGaN, ou toute autre couple des alliages des éléments III-V du tableau périodique, ainsi que des éléments comme Si, Ge, C...

- par ailleurs, le première et le deuxième matériau peuvent aussi être choisi par un alliage des éléments II-VI du tableau périodique, tel le HgTe.

- au moins 70% de l'énergie électrique générée par le champ électrique est localisée dans des zones de la couche séparatrice située entre les parties de chevauchement de la première piste et de la deuxième piste,

- la couche séparatrice présente une première épaisseur dans une première zone située entre les parties de chevauchement de la première piste et de la deuxième piste formant l'une des capacités, et une deuxième épaisseur dans une deuxième zone située entre les parties de chevauchement de la première piste et de la deuxième piste formant l'autre des capacités, la deuxième épaisseur étant différente de la première épaisseur,

- les parties de chevauchement de la deuxième piste sont espacées l'une de l'autre d'une distance d'espacement, et la couche séparatrice présente une épaisseur égale ou inférieure à la distance d'espacement,

- les parties de chevauchement de la deuxième piste sont espacées l'une de l'autre d'une distance d'espacement $L_x$, la boucle inductive présente une dimension longitudinale $L_y$, chaque partie de chevauchement présente une longueur W et une largeur Y. Les dimensions $L_x+2Y$ et $L_y+W+Y$ sont inférieures à la longueur d'onde de la résonance $\lambda$. La longueur d'onde de résonance, $\lambda$ est défini comme étant égale à $c/f_{res}$, où $c$ est la vitesse de la lumière dans le vide et $f_{res}$ est la fréquence de résonance du dispositif,

- l'épaisseur de la couche séparatrice est inférieure à $\lambda/2n$, où $n$ est l'indice de réfraction de la couche séparatrice et $\lambda$ est la longueur d'onde de résonance, $\lambda$ étant égale à $c/f_{res}$, où c est la vitesse de la lumière dans le vide et $f_{res}$ est la fréquence de résonance du dispositif,

- la fréquence de résonance est supérieure ou égale à 100 gigahertz et le dispositif fonctionne en régime quasi-statique à la fréquence de résonance (dans un « régime quasi-statique », la source du champ magnétique est essentiellement le courant qui circule dans les pistes conductrices, et non pas les variations du champ électrique dans le temps, encore connu comme « courant de déplacement »),

- le dispositif présente une ou plusieurs fréquence(s) de résonance comprise(s) entre 0.1 et 300 terahertz,

- chaque zone de la couche séparatrice située entre les parties de chevauchement de la première piste et de la deuxième piste formant une capacité présente un volume inférieur ou égal à $(\lambda/2n)^3$, où $n$ est l'indice de réfraction de la couche séparatrice et $\lambda$ est la longueur d'onde de résonance, $\lambda$ étant égale à $c/f_{res}$, où c est la vitesse de la lumière dans le vide et $f_{res}$ est la fréquence de résonance du dispositif,

- la première piste conductrice présente une forme rectiligne,

- la deuxième piste conductrice présente une forme de U ayant deux branches parallèles, les parties de chevauchement étant situées aux extrémités respectives des branches du U,

- la deuxième piste présente une forme asymétrique,

- chaque piste conductrice présente une partie d'extension pour raccorder les pistes conductrices à une source de courant pour alimenter le dispositif ou à un détecteur de courant pour détecter un courant extrait à partir du dispositif,

- le dispositif comprend un motif métallique, formant une antenne, couplé de manière capacitive ou inductive avec la deuxième piste conductrice, le motif métallique étant propre à collecter un rayonnement électromagnétique éclairant le dispositif.

L'invention concerne également un ensemble résonateur électrique, comprenant une pluralité de dispositifs tel que définis précédemment, un premier conducteur électrique raccordant électriquement les premières pistes entre elles et un deuxième conducteur électrique raccordant les deuxièmes pistes entre elles.

## PRESENTATION DES DESSINS

D'autres caractéristiques et avantages ressortiront encore de la description qui suit, laquelle est purement illustrative et non limitative, et doit être lue en regard des figures annexées, parmi lesquelles :

- la figure 1 représente de manière schématique un dispositif résonateur conforme à un mode de réalisation de l'invention,
- la figure 2 représente de manière schématique les dimensions du dispositif,
- la figure 3 représente de manière schématique le champ magnétique et le champ électrique générés par le dispositif,
- la figure 4 représente de manière schématique une distribution du champ électrique généré dans un plan (x, y) pour un premier exemple de résonateur,
- la figure 5 représente de manière schématique une distribution du champ magnétique dans le plan (x, y) pour le premier exemple de résonateur,
- la figure 6 représente de manière schématique un exemple de dispositif résonateur fabriqué sur un substrat en GaAs avec une couche séparatrice en $SiO_2$, et des parties métalliques en Or.
- la figure 7 représente de manière schématique une matrice de dispositifs résonateurs,
- les figures 8A à 8C sont des spectres de réflectivité obtenus pour des matrices de dispositifs résonateurs présentant différents jeux de paramètres,
- la figure 9 est un diagramme montrant les fréquences de résonance mesurées pour différentes géométries du dispositif résonateur, réparties en trois familles,
- la figure 10 est un diagramme comparatif montrant les fréquences expérimentales pour les trois familles de dispositifs résonateurs et les fréquences de résonance correspondantes obtenues par simulation numérique,
- les figures 11A à 11B représentent de manière schématique un circuit électrique équivalent,
- la figure 12 représente de manière schématique un dispositif résonateur comprenant une première structure quantique,
- la figure 13 représente de manière schématique un dispositif résonateur comprenant une deuxième structure quantique,
- la figure 14 représente de manière schématique un dispositif résonateur comprenant une première antenne couplée de manière inductive avec une piste du dispositif résonateur,
- la figure 15 représente de manière schématique un dispositif résonateur comprenant une deuxième antenne couplée de manière capacitive avec une piste du dispositif résonateur.
- la figure 16 représente de manière schématique un dispositif résonateur conforme à un deuxième mode de réalisation de l'invention,
- les figures 17 à 25 représentent de manière schématique différents modes de réalisation d'un dispositif résonateur conforme à l'invention,
- les figures 26A à 26G illustrent de manière schématique des étapes d'un procédé de fabrication d'un dispositif résonateur conforme à l'invention,
- la figure 27 représente de manière schématique une distribution du champ électrique généré dans un plan (x, y) pour un deuxième exemple de résonateur,
- la figure 28 représente de manière schématique une distribution du champ magnétique dans le plan (x, y) pour le deuxième exemple de résonateur,
- la figure 29 représente de manière schématique une distribution du champ électrique généré dans un plan (x, y) pour un troisième exemple de résonateur,
- la figure 30 représente de manière schématique une distribution du champ magnétique dans le plan (x, y) pour le troisième exemple de résonateur.
- la figure 31 représente de manière schématique la projection dans le plan du la boucle métallique supérieur du champ électrique généré à la fréquence du dispositif pour une première réalisation.
- la figure 32 représente de manière schématique la projection dans le plan du la boucle métallique supérieur du champ électrique généré à la fréquence du dispositif pour une deuxième réalisation.
- la figure 33 représente les spectres de transmission des réseau de résonateurs selon les réalisations des figures 31 et 32.

- les figures 34A à 34C représente une schéma en billet du mode de réalisation de la figure 32, avec des simulations du champ électrique et magnétique.
- les figures 35A à 35F montrent des réalisation des résonateurs avec des volume des capacités très petites, ainsi que des spectres réalisé sur réseaux de ces types de résonateurs.

## DESCRIPTION D'UN MODE DE REALISATION

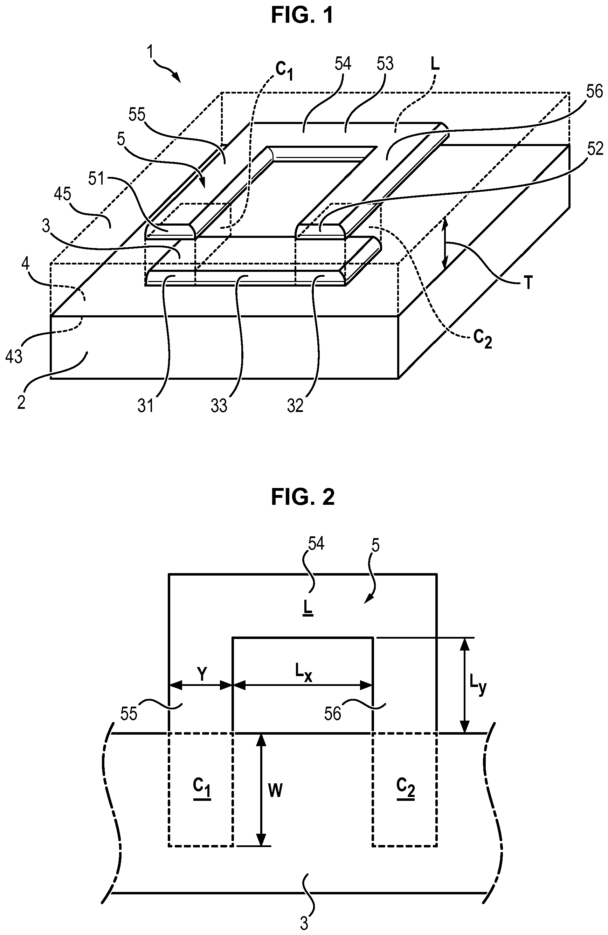

Sur la figure 1, le dispositif résonateur 1 représenté comprend un substrat 2, une première piste conductrice 3, une couche séparatrice 4 et une deuxième piste conductrice 5.

Le substrat 2 est formé en un matériau semi-conducteur, tel qu'en Arséniure de gallium (GaAs), en Phosphure d'Indium (InP) ou en Silicium (Si)par exemple.

La première piste conductrice 3 est formée en métal, par exemple par dépôt d'une ou plusieurs couche(s) métallique(s) sur le substrat 2. Le métal utilisé pour former les couches peut être de l'or, du titane, du platine, du nickel, ou du germanium ou des alliages de ces métaux, ou encore un matériau supraconducteur à haute température (tel que par exemple, $YBa_2Cu_3O_{7-x}$). La première piste 3 présente une forme rectiligne allongée, généralement rectangulaire. La première piste 3 comprend une première partie d'extrémité 31, une deuxième partie d'extrémité 32 et une partie intermédiaire 33 reliant des deux parties d'extrémité 31, 32 entre elles.

La couche séparatrice 4 est une hétérostructure quantique à la base de matériaux semi-conducteur, par exemple. La couche séparatrice 4 peut également être formée d'un empilement de couches de matériaux diélectriques tels que du dioxyde de silicium ($SiO_2$) ou du nitrure de silicium ($Si_3N_4$), avec l'hétérostructure quantique, dont l'une des couches est en graphène. La couche séparatrice 4 présente une forme générale plane avec une première face 43 et une deuxième face 45, opposée à la première face 43.

La deuxième piste conductrice 5 est également formée en métal, par exemple par dépôt d'une couche métallique sur la couche séparatrice 4. La deuxième piste conductrice 5 peut être formée dans le même métal que la première piste conductrice 3. La deuxième piste conductrice 5 comprend une première partie d'extrémité 51, une deuxième partie d'extrémité 52 et une partie intermédiaire 53 en forme de boucle (ou d'épingle) reliant les deux parties d'extrémité 51, 52 entre elles. Dans le mode de réalisation illustré sur la figure 1, la deuxième piste 5 présente globalement une forme de U avec une branche transversale 54 et deux branches longitudinales 55, 56 parallèles.

La première piste 3 est disposée en contact avec la première face 43 de la couche séparatrice 4 tandis que la deuxième piste 5 est disposée en contact avec la deuxième face 45 de la couche séparatrice 4. Autrement dit, la première et la deuxième pistes 3 et 5 sont disposées respectivement de part et d'autre de la couche séparatrice 4.

Par ailleurs, la première piste 3 et la deuxième piste 5 sont disposées l'une par rapport à l'autre de sorte que la première partie d'extrémité 51 de la deuxième piste 5 chevauche la première partie d'extrémité 31 de la première piste 3, et que la deuxième partie d'extrémité 52 de la deuxième piste 5 chevauche la deuxième partie d'extrémité 32 de la première piste 3.

De cette manière, les deux premières parties d'extrémité 31, 51 forment une première capacité $C_1$ et les deux deuxième parties d'extrémité 32, 52 forment une deuxième capacité $C_2$, la première capacité et la deuxième capacité étant espacées spatialement d'une de l'autre. Par ailleurs, les parties d'extrémité 51 et 52 forment également une troisième capacité $C_{fringe}$.

En outre, la partie en forme de boucle 53 de la deuxième piste forme une inductance L .

Le dispositif 1 se comporte comme un circuit résonateur électrique de type inductance-capacité. La fréquence de résonance $f_{res}$ du dispositif 1 dépend des dimensions de la première piste 3 et de la deuxième piste 5 ainsi que des dimensions des parties d'extrémité 31, 51, 32, 52 qui se chevauchent.

Comme illustré sur les figures 1 et 2, les paramètres géométriques du dispositif 1 sont les suivants :

- $T$ : épaisseur de la couche séparatrice 4,
- $Y$ : largeur des parties d'extrémité 31, 32, 51, 52 qui se chevauchent,
- $W$ : longueur des parties d'extrémité 31, 32, 51, 52 qui se chevauchent,
- $Y \times W$ : aire de chevauchement de chaque partie d'extrémité de la deuxième piste 5 avec la première piste 3,
- $L_x$ : longueur de la branche transversale 54 de la partie en forme de boucle 53,
- $L_y$ : longueur d'une branche longitudinale 55, 56 de la partie en forme de boucle (à l'exclusion des parties d'extrémités 31, 32, 51, 52 qui se chevauchent),
- $L_x + 2 \times L_y$ : longueur totale de la partie en forme de boucle 53 (à l'exclusion des parties d'extrémités 31, 32, 51, 52 qui se chevauchent).

Le dispositif 1 étant symétrique, les capacités $C_1$ et $C_2$ sont identiques. De plus, la capacité totale du dispositif vaut :

$$C = C_{fringe} + (1/C_1 + 1/C_2)^{-1}$$

La capacité C du dispositif 1 dépend des paramètres géométriques *Y, W* et *T*. L'inductance *L* du dispositif dépend des paramètres géométriques $L_x$, $L_y$, *Y, W* et *T*.

La fréquence de résonance $f_{res}$ du dispositif s'exprime :

$$f_{res} = \frac{1}{2\pi\sqrt{LC}}$$

La fréquence propre $f_{res}$ peut être accordée dans la gamme de fréquences terahertz par un choix approprié des paramètres géométriques *Y, W, T*, $L_x$ et $L_y$.

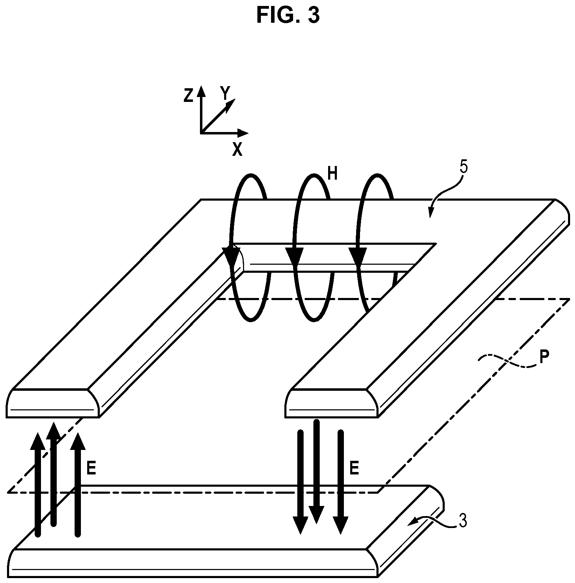

Comme illustré sur la figure 3, lorsque le dispositif 1 est excité à sa fréquence de résonance $f_{res}$, chaque capacité génère un champ électrique E à l'intérieur de la couche séparatrice 4, le champ électrique E généré présente une direction principale parallèle à l'épaisseur de la couche séparatrice 4 (c'est-à-dire perpendiculaire aux faces 41 et 42 de la couche séparatrice 4).

Par ailleurs, la partie en forme de boucle 53 de la deuxième piste 5 génère un champ magnétique H autour de la partie en forme de boucle 53. La partie du champ magnétique H générée à l'intérieur de la boucle présente également une direction parallèle à l'épaisseur de la couche séparatrice 4 (c'est-à-dire perpendiculaire aux faces 41 et 42 de la couche séparatrice 4).

De cette manière, le champ magnétique H généré par la partie en forme de boucle 53 dans la couche séparatrice 4 présente une composante principale non nulle $H_z$ s'étendant selon une direction parallèle à l'épaisseur de la couche séparatrice 4, et parallèle à la composante principale du champ électrique $E_z$ généré par les capacités $C_1$ et $C_2$. De plus, dans la couche séparatrice 4, la composante $H_z$ est supérieure aux autres composantes du champ $H_y$ et $H_x$. Par exemple une simulation numérique avec un dispositif ayant pour paramètres géométriques $T = W = Y = 2\mu m$, et $L_x = L_y = 2\mu m$ montre que la composante $H_z$ est quasiment homogène dans la surface de la boucle, et que $H_z/H_x$ = 1.6 et $H_z/H_y$ =1.4.

## EXEMPLE 1

Une simulation numérique du fonctionnement du dispositif résonateur 1 a été réalisée.

Les paramètres géométriques utilisés pour la simulation sont les suivants: $T = W = Y = 2\mu m$ et $L_x = L_y = 4\mu m$. La couche séparatrice 4 est une couche en matériau diélectrique d'indice optique $n_1$ =2. Le substrat 2 possède un indice optique $n_2$ =3,5. Un simulateur numérique commercial basé sur la méthode des éléments finis permet de déterminer que la fréquence de résonance d'un tel dispositif est égale à $f_{res}$ = 4,2$THz$.

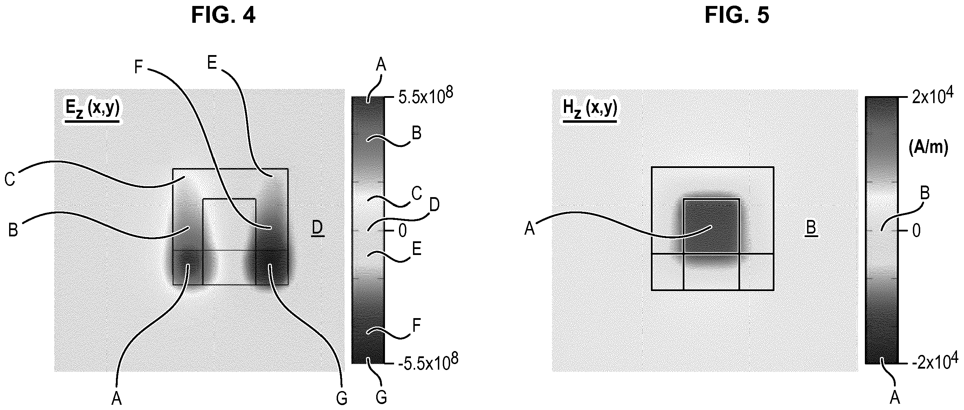

La figure 4 représente de manière schématique l'intensité de la composante $E_z$ du champ électrique généré, selon la direction z parallèle à l'épaisseur de la couche séparatrice 4. La figure 4 montre une simulation numérique 3D de la distribution de la composante $E_z(x,y)$ dans un plan P (x, y) parallèle aux faces 41 et 42 de la couche séparatrice 4 et passant par le milieu de la couche séparatrice 4. Autrement dit, le plan P est un plan médian perpendiculaire à l'épaisseur de la couche séparatrice 4.

La figure 5 représente de manière schématique l'intensité de la composante $H_z$ du champ magnétique généré, selon la direction z parallèle à l'épaisseur de la couche séparatrice 4. La figure 5 montre une simulation numérique 3D de la distribution de la composante $H_z(x,y)$ dans le plan P (x, y) médian qui passe au milieu de la couche séparatrice 4 (par exemple diélectrique), à égale distance des pistes conductrices 3 et 5.

La plupart de l'énergie électrique (proportionnelle au carré des champs ($|E_z|^2$) est stockée dans la composante $E_z$, et la plupart de l'énergie magnétique (proportionnelle au carré des champs ($|H_z|^2$) est stockée dans la composante $H_z$.

Les autres composantes du champ électrique sont négligeables par rapport à $E_z$ (par exemple $E_z/E_y$ est voisin de 4) et les autres composantes du champ magnétique sont inférieures à $H_z$ dans la couche séparatrice.

Comme illustré sur les figures 4 et 5, le champ électrique $E_z(x,y)$ généré par le dispositif résonateur est concentré dans le volume $T \times W \times Y$ de la couche séparatrice 4 situé entre les parties d'extrémité 31, 51 et 32, 52 de la première piste 3 et de la deuxième piste 5 qui se chevauchent (ce volume est appelé zones capacitives). En revanche, le champ magnétique $H_z(x,y)$ est localisé autour de la partie en forme de boucle $L_x \times L_y$ de la deuxième piste 5 (cette partie est appelée zone inductive). Le champ magnétique H est ainsi spatialement séparé du champ électrique E.

La géométrie du dispositif résonateur 1 permet d'ajuster de manière indépendante la capacité C et l'inductance L du dispositif résonateur. Pour une fréquence propre $f_{res}$ donnée, il est possible d'ajuster les paramètres géométriques de manière à obtenir une faible capacité C et une forte inductance L. Cela permet d'ajuster de manière indépendante la composante électrique $E_z$ et la composante magnétique $H_z$ du champ généré dans la couche séparatrice 4.

En particulier, il est possible de réduire la zone $T \times W \times Y$ aux dépens de la boucle $L_x \times L_y$ afin de réduire le volume occupé par le champ électrique, toute en gardant la même fréquence de résonance $f_{res}$.

## EXEMPLES 2 ET 3

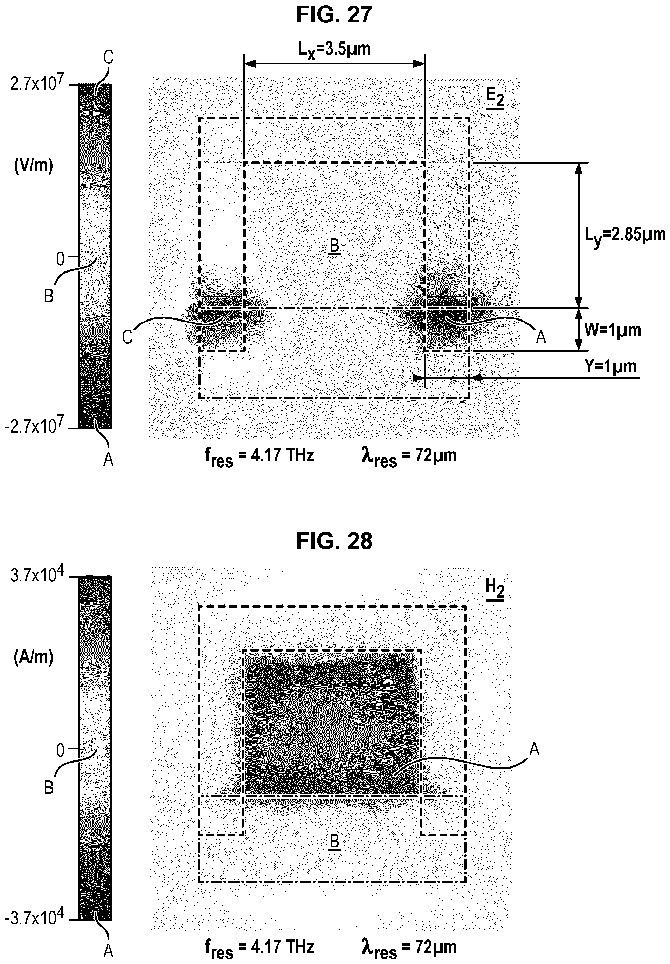

Cette propriété est également illustrée par des simulations numériques de deux autres exemples de dispositifs présentées sur les figures 27 à 30.

Le dispositif illustré sur les figures 27 et 28 présente les paramètres géométriques suivants: $L_x$=3.5$\mu$m, $L_y$=2.85$\mu$m, W=1$\mu$m, Y=1$\mu$m et T=0.5$\mu$m. Ce dispositif présente une fréquence de résonance $f_{res}$= 4.17 THz.

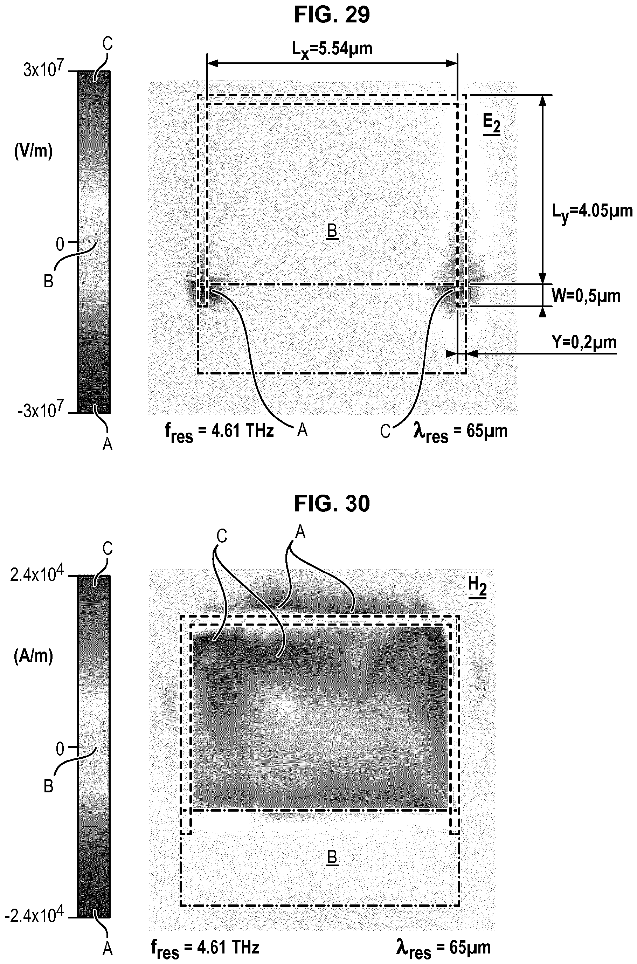

Le dispositif illustré sur les figures 29 et 30 présente les paramètres géométriques suivants : $L_x$=5.54$\mu$m, $L_y$=4.05$\mu$m, $W$=0.2$\mu$m, $Y$=0.5$\mu$m et $T$=0.5$\mu$m. Ce dispositif présente une fréquence de résonance $f_{res}$= 4.61 THz.

Le trois exemples de dispositifs des figures 4 et 5, 27 et 28, 29 et 30 présentent donc des fréquences de résonances similaires, alors que la zone occupée par le champ électrique est progressivement réduite de $TxWxY$ = 8$\mu$m$^3$ (Figures 4 et 5) à $TxWxY$ = 0.05 $\mu$m$^3$ (Figures 29 et 30).

Ainsi, la séparation spatiale des champs électrique et magnétique permet de faire varier le rapport entre les dimensions de la boucle inductive et celles des zones capacitives.

Par ailleurs si les champs E et H sont spatialement séparés, alors E est inversement proportionnel à la racine carrée du volume des parties capacitives, comme décrit ci-après.

Le dispositif permet ainsi de concentrer le champ électrique E dans un volume $V_c = T \times W \times Y$ très faible par rapport à la limite de diffraction $\lambda_{res}^3$, où $\lambda_{res} = \dfrac{c}{f_{res}}$ est la longueur d'onde de résonance et c est la vitesse de la lumière dans le vide.

Par exemple, avec le dispositif illustré sur les figures 29 et 30, un rapport $\dfrac{\lambda_{res}^{3}}{V_c} = 5,5.10^6$ est obtenu.

Grâce à cette propriété, il est possible d'obtenir des valeurs d'intensité importantes du champ électrique $E_z$. En effet, lorsque le dispositif résonateur est excité à sa fréquence propre $f_{res}$, le dispositif est capable de stocker une énergie électromagnétique finie U, la moitié de cette énergie étant de nature électrique et vérifie la relation :

$$\varepsilon \varepsilon_0 E_z^{\,2} V_c = 2 \times U = \text{constante}$$

où $\varepsilon = n_1^2$ et $\varepsilon_0$ = 8,854.10$^{-12}$ $F/M$ est la constante diélectrique (ou permittivité du vide).

Dans le dispositif résonateur 1 proposé, les paramètres géométriques $T$, $W$ et $Y$ des zones capacitives peuvent être réduits, de sorte que pour une énergie électromagnétique U donnée, le champ électrique $E_z$ peut être augmenté.

Par ailleurs, dans ce dispositif résonateur 1, le champ électrique E et le champ magnétique H sont parallèles l'un à l'autre, ce qui montre que la résonance du dispositif n'est pas liée à des effets de propagation comme la plupart des dispositifs résonateurs optoélectroniques connus.

Le dispositif présente deux pistes métalliques de forme différente et séparées par une hétérostructure quantique, qui résonnent ensemble pour faire un champ électrique concentrique dans l'hétérostructure quantique séparé du champ magnétique et parallèle à ce dernier, ce qui n'est pas décrit par aucun document de l'état de l'art.

Dans l'invention, il existe une résonance inductance capacité car :

    i) Les pistes métalliques sont finis, ce qui permet une accumulation des charges au voisinage des parties d'extrémité de chevauchement 31, 32, 51, 52. Par ailleurs, Il suffit que l'une des paires ( (31), (32)) ou ((51), (52)) soit située dans les extrémités de l'une des parties 3 ou 5, mais pas nécessairement les deux à la fois.

    ii) Le nombre des parties d'extrémité de chevauchement 31, 32, 51, 52 est paire (deux ou multiple de 2).

Ainsi, les conditions i) et ii) permettent une accumulation des charges électriques de signes opposées dans :

-   entre les parties 51 et 52 de la première piste 3, d'une part ;
-   entre les parties 31 et 32 de la deuxième piste 5, d'autre part.

Par ailleurs, les charges accumulées dans les parties de chevauchement entre l'extrémité 51 et l'extrémité 31 d'une part, et entre l'extrémité 52 et l'extrémité 32 d'autre part sont de signes opposées.

En effet, la conservation des charges indique que la somme totale des charges dans une même piste doit être nulle.

Seulement dans ce cas-là, ou il y a formation des pôles de charges opposées entre deux extrémités 31, 51, et 32, 52 en regard des deux pistes que le dispositif crée la capacité.

Ce qui est illustré sur la figure 3 et sur la valeur du champ électrique positif en A et négatif en G, sur la figure 4, C et A sur la figure 27, A et C sur la figure 29.

Ainsi il y a un va et vient (ou oscillation) des charges électriques dans chaque piste métallique, et de façon opposée entre les deux pistes métalliques, à la fréquence de résonance du résonateur tridimensionnel.

## AUTRES EXEMPLES

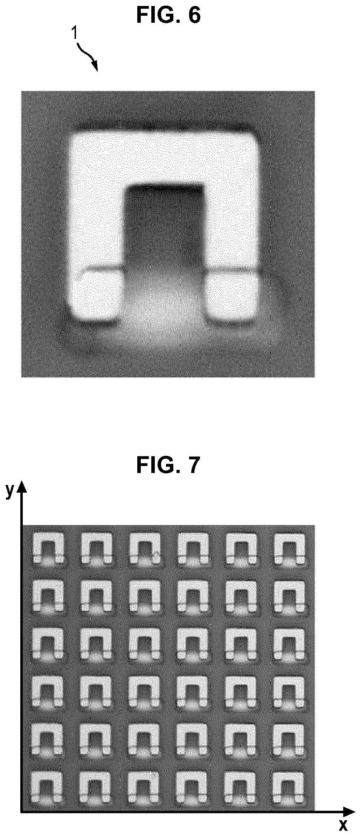

Des prototypes de dispositifs résonateurs ont été réalisés avec les paramètres géométriques suivants: $T = Y = 2\mu m$, $W$, $L_x$ et $L_y$ prenant des valeurs de $2\mu m$, $4\mu m$, $6\mu m$ et $8\mu m$. La figure 6 représente l'un des dispositifs résonateurs.

Chaque dispositif résonateur comprend un substrat en GaAs, une couche séparatrice en $SiO_2$, et des pistes conductrices en or. Une géométrie particulière est notée avec un triplet de valeurs $W,L_x,L_y$. Par exemple, le triplet « 242 » désigne un dispositif résonateur présentant les paramètres géométriques suivants : $W = 2\mu m$, $L_x = 4\mu m$ et $L_y = 2\mu m$.

Pour chaque jeu de paramètres $(W,L_x,L_y)$, des matrices de dispositifs ont été réalisées en disposant un grand nombre de dispositifs résonateurs sur des panneaux présentant des dimensions de $3mm \times 3mm$. Chaque panneau supporte une matrice de résonateurs identiques, agencés selon une disposition périodique. La figure 7 représente l'une des matrices de dispositifs résonateurs ainsi réalisée.

Des mesures de réflectivité ont ensuite été effectuées sur chaque panneau. L'utilisation d'une disposition périodique de dispositifs résonateurs 1 identiques permet de mettre en évidence les fréquences de résonance.

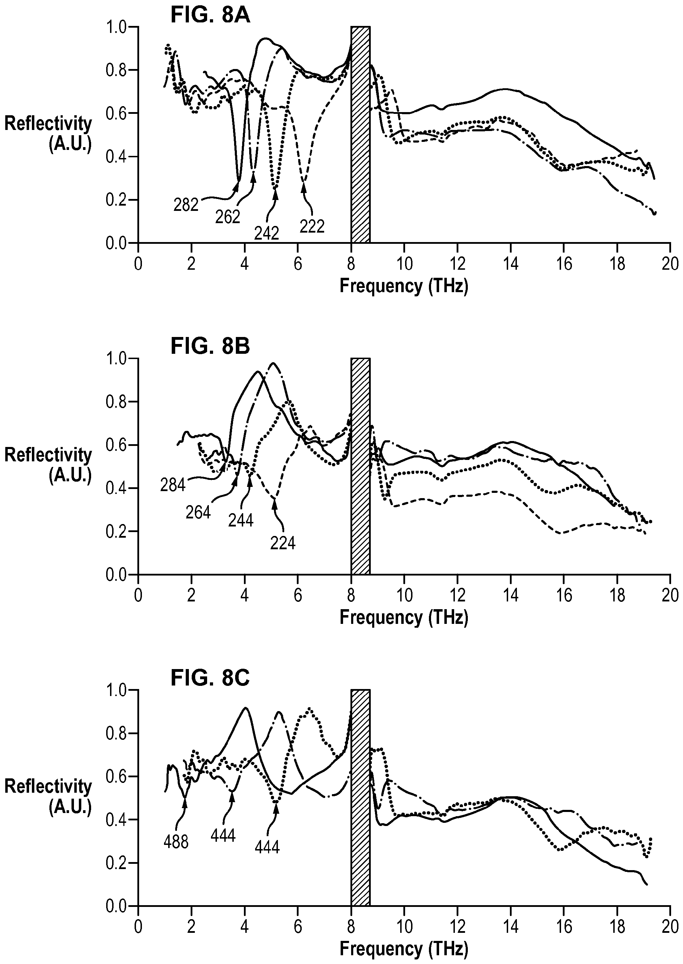

Les figures 8A à 8C montrent les spectres de réflectivité obtenus pour les différentes matrices de dispositifs résonateurs présentant différents jeux de paramètres. Les spectres ont été obtenus en incidence quasi-normale sur les panneaux, avec une lumière polarisée, le vecteur du champ électrique de la lumière étant orienté parallèlement à la longueur de la piste de masse 3.

Les spectres représentés sur les figures 8A à 8C présentent des minima de réflectivité correspondant à une absorption résonante de la lumière par les dispositifs résonateurs. Dans ces spectres, aucun mode d'ordre supérieur n'est visible, alors que dans la plupart des dispositifs résonateurs THz étudiés en réflectivité, des modes d'ordres supérieurs dus aux effets de propagation sont toujours présents.

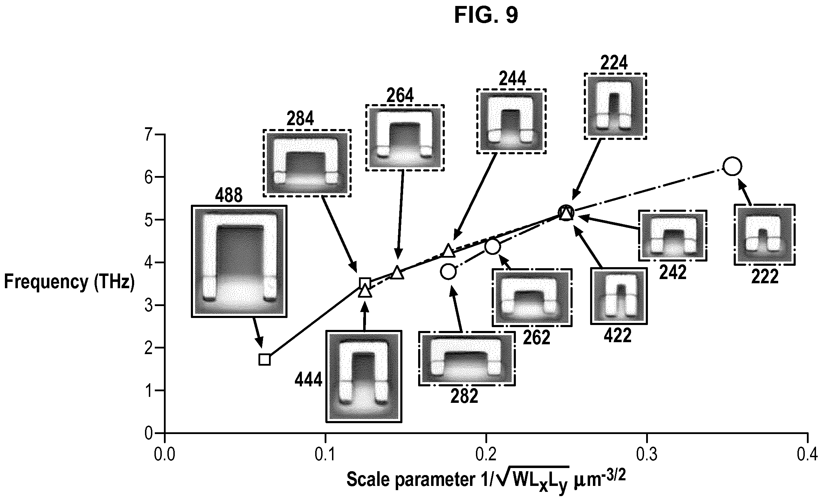

La figure 9 est un diagramme regroupant les fréquences de résonance mesurées pour les différentes géométries du dispositif résonateur, en fonction d'un paramètre d'échelle : $p = \dfrac{1}{\sqrt{WL_xL_y}}$ .

La signification de ce paramètre d'échelle peut être comprise de la façon suivante. Si la boucle inductive 5 est assimilée à un conducteur filiforme, et les parties capacitive 51/31 et 52/32 à des condensateurs plans, alors les capacités $C$ et l'inductance $L$ s'expriment en première approximation selon les formules :

$$C = \varepsilon\varepsilon_0 \frac{WY}{T}$$

$$L = \mu_0 \frac{L_xL_y}{h}$$

où $h$ est l'épaisseur de la deuxième piste conductrice ($h = 0,25\mu m$ dans les exemples présents) et $\mu_0$ est la constante magnétique ($\mu_0 = 4\pi.10^{-7}$ T.m/A).

Les paramètres géométriques $Y$, $T$ et $H$ étant fixes, la fréquence de résonance s'exprime comme :

$$f_{res} = \frac{1}{2\pi\sqrt{CL}} \approx \frac{1}{2\pi\sqrt{WL_xL_y}} c\sqrt{\frac{Th}{Y}} = pxConst$$

En première approximation, la fréquence de résonance est donc proportionnelle au paramètre $p$.

Il est en effet possible d'observer que les dispositifs résonateurs ayant le même produit $W \times L_x \times L_y$ présentent des fréquences de résonance identiques.

Par exemple, comme cela apparait sur la figure 9, les dispositifs résonateurs « 224 », « 242 » et « 422 » résonnent à la même fréquence $f_{res}$ =4,5THz. Il est ainsi possible d'augmenter les dimensions de chaque capacité d'un facteur 2 (en passant de $W=4\mu m$ pour le dispositif résonateur « 422 » à $W=2\mu m$ pour le dispositif résonateur « 224 »), tout en conservant la même fréquence de résonance.

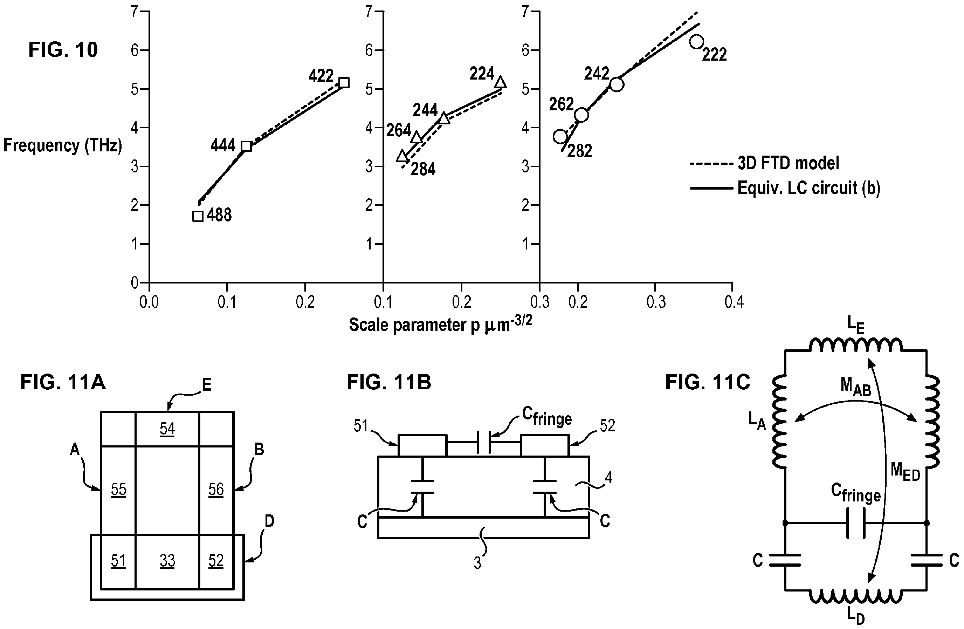

La figure 10 est un diagramme comparatif montrant les fréquences expérimentales pour les trois familles de dispositifs résonateurs et les fréquences de résonance correspondantes obtenues par deux méthodes différentes. La première méthode est une simulation numérique électromagnétique de la structure par la méthode des éléments finis (courbes en pointillés sur la Figure 11). La seconde méthode est une expression analytique de la fréquence de résonance à la base d'un circuit équivalent (Figures 11A à 11C).

Pour construire le circuit équivalent, les pistes métalliques ont été divisées en blocs rectangulaires (par exemple, les blocs A, B, D et E sur les figures 11A à 11C). Le courant induit par la résonance électromagnétique passe par ces parties. Les auto-inductances correspondantes $L_A$, $L_B$, $L_D$ et $L_E$ et les inductances mutuelles $M_{AB}$ et $M_{ED}$ ont été calculées. Pour ce calcul, l'épaisseur de peau (pénétration du champ électromagnétique dans le métal) a été considérée comme très faible par rapport aux dimensions de la structure. Cette approximation est justifiée dans le domaine des hautes fréquences, où l'épaisseur de peau vaut quelques dizaines de nanomètres au plus. Il est ainsi possible d'estimer les valeurs de $L_A$, $L_B$, $L_D$ et $L_E$ et $M_{AB}$ et $M_{ED}$ en fonction des paramètres géométriques de la structure, en utilisant les équations (8) et (18) de la référence Hoer, C. and C. Love, « Exact inductance equations for rectangular conductors with application to more complicated geometries, » J. Res. NBS, Vol. 69C, No. 2, 127-137, (1965).

Les capacités $C_1$ et $C_2$ sont estimées selon la formule :

$$C_1 = C_2 = \varepsilon\varepsilon_0 \frac{WY}{T} + \frac{\varepsilon\varepsilon_0 W}{\pi}\left(1 + \ln\left(\frac{2\pi Y}{T}\right)\right) + \frac{\varepsilon\varepsilon_0 Y}{\pi}\left(1 + \ln\left(\frac{2\pi W}{T}\right)\right)$$

Dans cette formule, les deuxième et troisième termes permettent de prendre en compte « les champs de fuite » ou encore la courbure des lignes de champ électrique entre les parties 51 et 31 (52 et 32), d'après les résultats de Palmer (H. B. Palmer, « Capacitance of a parallel-plate capacitor by the Schwartz-Christoffel transformation », Trans. AIEE, Vol. 56, pp. 363, March 1927.)

La capacité $C_{fringe}$ permet de tenir compte des lignes de champ entre les parties 51 et 52. Cette capacité peut être estimée d'après les formules analytiques données dans la référence « Inder Bahl, Lumped Elements for RF and Microwave Circuits », 2003 ARTECH HOUSE, INC. 685 Canton Street Norwood, MA 02062, page 458, par les équations 14.47 a, 14.47b, 14.48:

La fréquence de résonance $f_{res}$ est alors donnée par la formule :

$$f_{res} = \frac{1}{\sqrt{\left(L_A + L_B + L_D + L_E - 2M_{AB} - 2M_{DE}\right) \times \left(C_{fringe} + C_1 C_2 / (C_1 + C_2)\right)}}$$

Les valeurs estimées d'après ce modèle sont représentées sur la Figure 10 en lignes continues. Les deux méthodes reproduisent bien les fréquences de résonances mesurées . l'avantage du modèle analytique est qu'il permet d'estimer $f_{res}$ sans avoir recours aux simulations numériques qui requièrent plusieurs heures et une quantité de mémoire d'ordinateur importante.

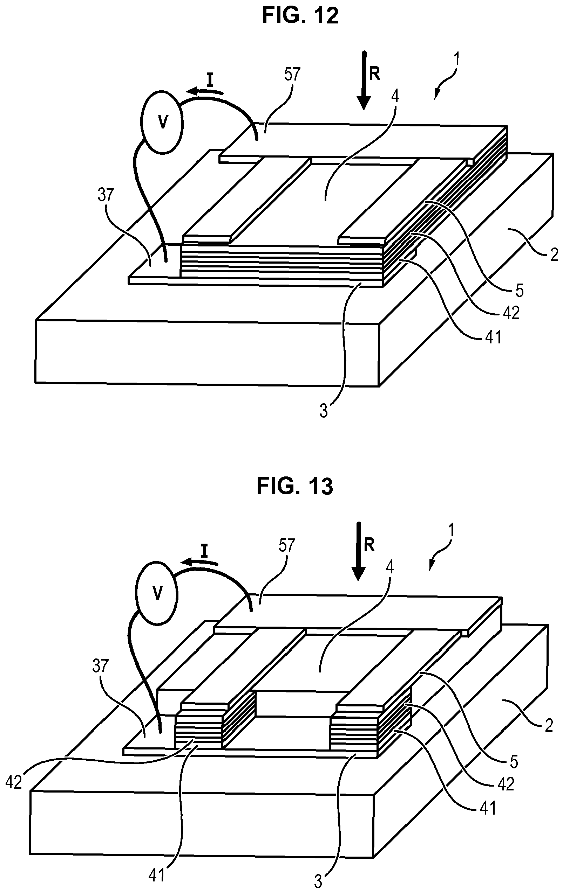

La figure 12 représente de manière schématique un dispositif résonateur comprenant une première structure quantique.

Le dispositif résonateur 1 illustré sur cette figure montre comment la couche séparatrice 4 est formée dans son intégralité d'une hétérostructure quantique agencée entre la première piste conductrice 3 et la deuxième piste conductrice 5.

L'hétérostructure quantique comprend un empilement de couches formées de matériaux différents. L'hétérostructure quantique représentée sur la figure 12 comprend un empilement de couches 41 d'un premier matériau semiconducteur et de couches 42 d'un deuxième matériau semi-conducteur, différent du premier matériau. Les couches 41 du premier matériau sont disposées en alternance avec les couches 42 du deuxième matériau. Chaque couche 41, 42 de l'empilement s'étend parallèlement aux faces 43 et 45 de la couche séparatrice 4. Autrement dit, chaque couche 41, 42 de l'empilement s'étend perpendiculairement à la direction de l'épaisseur de la couche séparatrice 4.

Le premier et le deuxième matériaux peuvent par exemple être choisis parmi : GaAs et $Ga_{1-x}Al_xAs$, GaAs et AlGeAs, InAs et AlSb, GaN.

Par ailleurs, la première piste 3 comprend une première partie d'extension 37 et la deuxième piste 5 comprend une deuxième partie d'extension 57. La première partie d'extension 37 et la deuxième partie d'extension 57 permettent de raccorder les pistes conductrices 3 et 5 à une source de tension V afin d'exciter les transitions quantiques dans l'hétérostructure. La première partie d'extension 37 s'étend dans le prolongement de la première piste 3. La deuxième partie d'extension 57 s'étend dans le prolongement de la branche transversale 54 de la deuxième piste 5.

L'hétérostructure est propre à absorber un rayonnement électromagnétique R dans une bande de fréquence donnée et à le convertir en courant électrique continu I (ou photocourant). Les parties d'extension 37 et 57 de la première piste 3 et de la deuxième piste 5 peuvent être raccordées à un détecteur de courant afin de détecter le courant électrique I généré par le dispositif résonateur 1.

La figure 13 représente de manière schématique un dispositif résonateur 1 comprenant une deuxième structure quantique.

Le dispositif résonateur 1 illustré sur cette figure montre comment la couche séparatrice 4 comprend des hétérostructures quantiques agencées uniquement dans les zones capacitives, c'est-à-dire entre les parties 31 et 51, 32 et 52 la première piste conductrice 3 et de la deuxième piste conductrice 5 qui se chevauchent. Le reste de la couche séparatrice 4 est formée en un matériau isolant. L'avantage de cette disposition est que le photo-courant est récolté uniquement sous les zones 31/51 et 32/52, dans lesquelles le champ électrique est particulièrement fort.

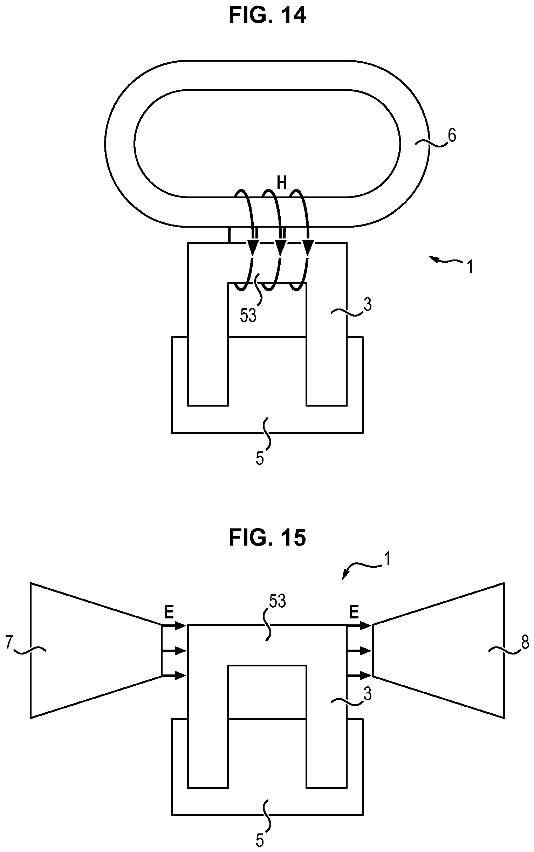

La figure 14 représente de manière schématique un dispositif résonateur 1 comprenant une première antenne couplée de manière inductive avec une piste du dispositif résonateur.

La première antenne comprend une troisième piste conductrice 6 formée sur la deuxième face 45 de la couche séparatrice 4, et agencée de manière à être couplée de manière inductive avec la partie en forme de boucle 53 de la deuxième piste 5. La première antenne permet d'augmenter l'efficacité de couplage du dispositif résonateur 1 avec le rayonnement électromagnétique incident R.

La figure 15 représente de manière schématique un dispositif résonateur 1 comprenant une deuxième antenne couplée de manière capacitive avec une piste du dispositif résonateur.

La deuxième antenne comprend une quatrième 7 et une cinquième piste 8 conductrice formées sur la deuxième face 45 de la couche séparatrice 4, et agencées de manière à être couplée de manière capacitive avec la partie en forme de boucle 53 de la deuxième piste 5.

## AUTRES MODES DE REALISATION

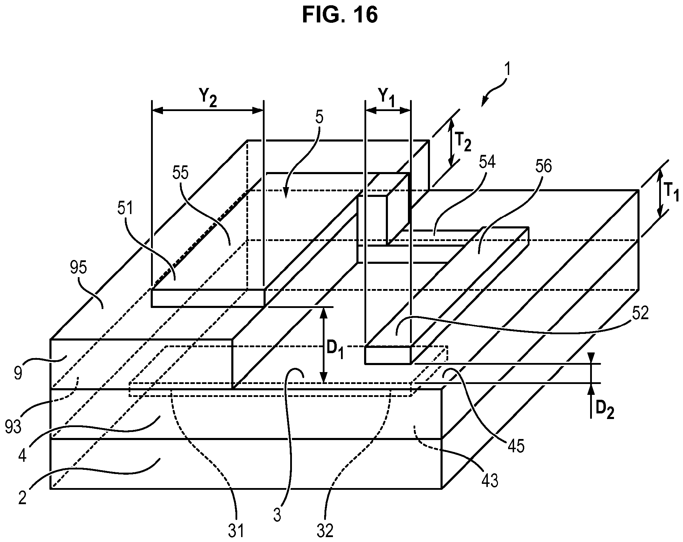

La figure 16 représente de manière schématique un dispositif résonateur 1 conforme à un deuxième mode de réalisation de l'invention.

Dans ce deuxième mode de réalisation, le dispositif résonateur 1 comprend une première couche séparatrice 4 et une deuxième couche séparatrice 9. La deuxième couche séparatrice 9 s'étend sur la première couche séparatrice 4. Cependant, la deuxième couche séparatrice 9 présente des dimensions différentes des dimensions de la première couche séparatrice 4.

La deuxième couche séparatrice présente une première face 93 et une deuxième face 95, opposée à la première face 93. La deuxième couche séparatrice 9 recouvre la première couche séparatrice 4, la première face 93 de la deuxième couche séparatrice 9 étant en contact avec la deuxième face 45 de la première couche séparatrice 4.

La première piste 3 est formée sur la première face 43 de la première couche séparatrice 4, tandis que la deuxième piste 5 est formée en partie sur la deuxième face 95 de la deuxième couche séparatrice 9 et en partie sur la deuxième face 45 de la première couche séparatrice 4.

Plus précisément, la deuxième piste 5 comprend une branche transversale 54 et deux branches longitudinales parallèles 55, 56, dont une première branche longitudinale 56 s'étendant sur la deuxième face 45 de la première couche séparatrice 4 et une deuxième branche longitudinale 55 s'étendant sur la deuxième face 95 de la deuxième couche séparatrice 9.

La première piste 3 et la deuxième piste 5 sont disposées l'une par rapport à l'autre de sorte que la première partie d'extrémité 51 de la deuxième piste 5 chevauche la première partie d'extrémité 31 de la deuxième piste 3, et que la deuxième partie d'extrémité 52 de la deuxième piste 5 chevauche la deuxième partie d'extrémité 32 de la première piste 3.

Cependant, les premières parties d'extrémité 31 et 51 sont séparées l'une de l'autre d'une première distance $D_1$, tandis que les deuxièmes parties d'extrémité 32 et 52 sont séparées l'une de l'autre d'une deuxième distance $D_2$, inférieure à la première distance $D_1$. La première distance $D_1$ est égale à l'épaisseur $T_1$ de la première couche séparatrice 4. La deuxième distance $D_2$ est égale à la somme des épaisseurs $T_1$ et $T_2$ de la première couche séparatrice 4 et de la deuxième couche séparatrice 9.

Par ailleurs, la deuxième piste conductrice 5 présente une forme asymétrique. Les dimensions de la deuxième branche longitudinale 55 sont différentes des dimensions de la première branche longitudinale 56. En particulier, la deuxième branche longitudinale 55 présente une largeur $Y_1$ supérieure à la largeur $Y_2$ de la première branche longitudinale 56.

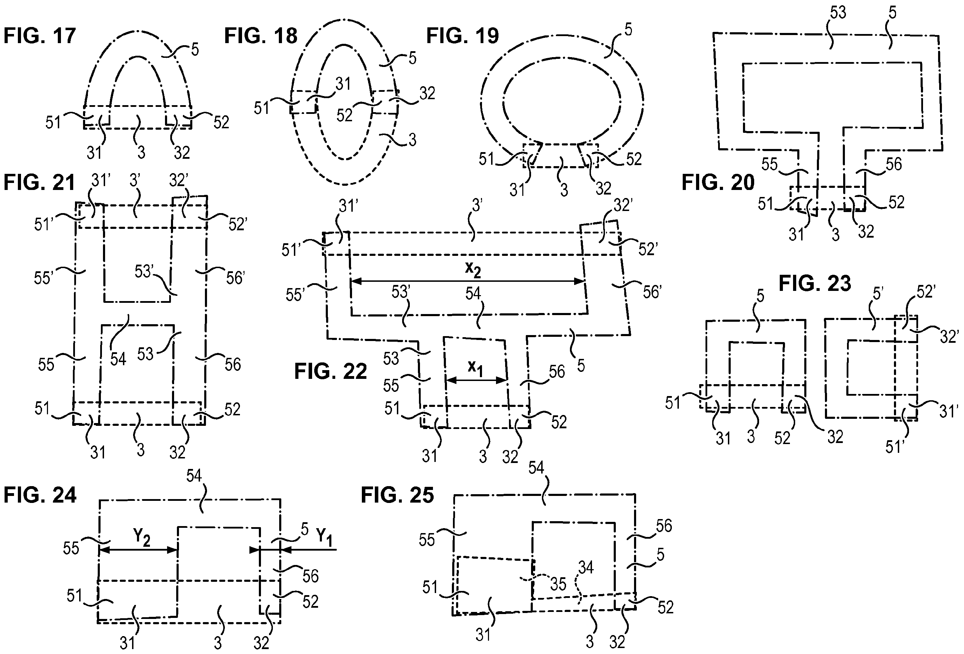

Les figures 17 à 25 représentent de manière schématique différents autres modes de réalisation d'un dispositif résonateur 1 conforme à l'invention,

Sur la figure 17, la première piste conductrice 3 présente une forme rectiligne. La deuxième piste conductrice 5 présente une forme arquée.

Sur la figure 18, la première piste conductrice 3 et la deuxième piste conductrice 5 présentent chacune une forme de U. La première piste 3 et la deuxième piste 5 sont disposées l'une par rapport à l'autre de sorte que seules les parties d'extrémité 31 et 51, 32 et 52 des pistes 3 et 5 se chevauchent.

Sur la figure 19, la première piste conductrice 3 présente une forme rectiligne. La deuxième piste conductrice 5 présente une forme de C.

Sur la figure 20, la première piste conductrice 3 présente une forme rectiligne. La deuxième piste conductrice 5 présente une partie 53 en forme de boucle rectangulaire ouverte et deux branches longitudinales 55, 56 s'étendant à partir de la partie en forme de boucle 53. Chaque branche longitudinale 55, 56 présente une partie d'extrémité 51, 52 qui chevauche une partie d'extrémité 31, 32 respective de la première piste 3.

Sur la figure 21, le dispositif comprend deux premières pistes conductrices rectilignes 3 et 3' et une deuxième piste conductrice 5 en forme de H. Les premières pistes conductrices 3 et 3' s'étendent parallèlement l'une à l'autre. La deuxième piste conductrice 5 comprend deux parties en forme de boucle 53 et 53' présentant une branche transversale 54 commune et quatre branches longitudinales 55, 56, 55', 56' s'étendant perpendiculairement à la branche transversale 54. Chaque branche longitudinale 55, 56, 55', 56' présente une partie d'extrémité 51, 52, 51', 52'. Les premières pistes 3, 3' et la deuxième piste 5 sont agencées les unes par rapport à l'autre de sorte que chaque partie d'extrémité 51, 52, 51', 52' de la deuxième piste 5 chevauche une partie d'extrémité respective 31, 32, 31', 32' de l'une des premières pistes 3, 3'.

Sur la figure 22, le dispositif comprend également deux premières pistes conductrices rectilignes 3 et 3', et une deuxième piste conductrice 5. Les premières pistes conductrices 3, 3' s'étendent parallèlement l'une à l'autre. Les premières pistes 3 et 3' présentent des longueurs différentes. La deuxième piste 5 comprend deux parties en forme de boucle 53 et 53' présentant une branche transversale commune 54 et quatre branches longitudinales 55, 56, 55', 56' s'étendant à partir de la branche transversale 54. Plus précisément, la deuxième piste 5 présente une première paire de branches longitudinales 55, 56 et une deuxième paire de branches longitudinales 55', 56'. Les branches longitudinales 55, 56 de la première paire sont espacées l'une de l'autre d'une première distance $L_{x1}$. Les branches longitudinales 55', 56' de la deuxième paire sont espacées l'une de l'autre d'une deuxième distance $L_{x2}$. Les premières pistes 3, 3' et la deuxième piste 5 sont agencées les unes par rapport à l'autre de sorte que les parties d'extrémité 51, 52 des branches 55, 56 de la première paire chevauchent les parties d'extrémité 31, 32 de l'une des premières pistes 3 et les parties d'extrémité 51', 52' des branches 55', 56' de la deuxième paire chevauchent les parties d'extrémité 31', 32' de l'autre première piste 3'.

Sur la figure 23, le dispositif comprend deux premières pistes rectilignes 3 et 3', et deux deuxièmes pistes 5 et 5' en forme de U. Chaque deuxième piste 5, 5' présente des parties d'extrémité 51, 52, et 51', 52' qui chevauchent les parties d'extrémité 31, 32, et 31', 32' de l'une des premières pistes 3, 3'. Les premières pistes 3 et 3' sont identiques entre elles, mais sont disposées perpendiculairement l'une par rapport à l'autre. De même, les deuxième pistes 5, 5' sont identiques entre elles mais sont tournées de 90 degrés l'une par rapport à l'autre.

Sur la figure 24, le dispositif comprend une première piste rectiligne 3 et une deuxième piste 5 en forme de U. La deuxième piste 5 comprend une branche transversale 54 et deux branches longitudinales 55, 56 parallèles. Les branches longitudinales 55, 56 présentent des largeurs $Y_1$ et $Y_2$ différentes l'une de l'autre. La première piste 3 et la deuxième piste 5 sont disposées l'une par rapport à l'autre de sorte que la première partie d'extrémité 51 de la deuxième piste 5 chevauche la première partie d'extrémité 31 de la première piste 3, et que la deuxième partie d'extrémité 52 de la deuxième piste 5 chevauche la deuxième partie d'extrémité 32 de la première piste 3.

Sur la figure 25, le dispositif comprend une première piste 3 en forme de L ayant une branche transversale 34 et une branche longitudinale 35. La branche longitudinale 35 de la première piste 3 chevauche en partie l'une des branches longitudinales 55 de la deuxième piste 5. La partie d'extrémité 32 de la branche transversale 34 de la première piste 3 chevauche la partie d'extrémité 52 de l'autre branche longitudinale 56 de la deuxième piste 5.

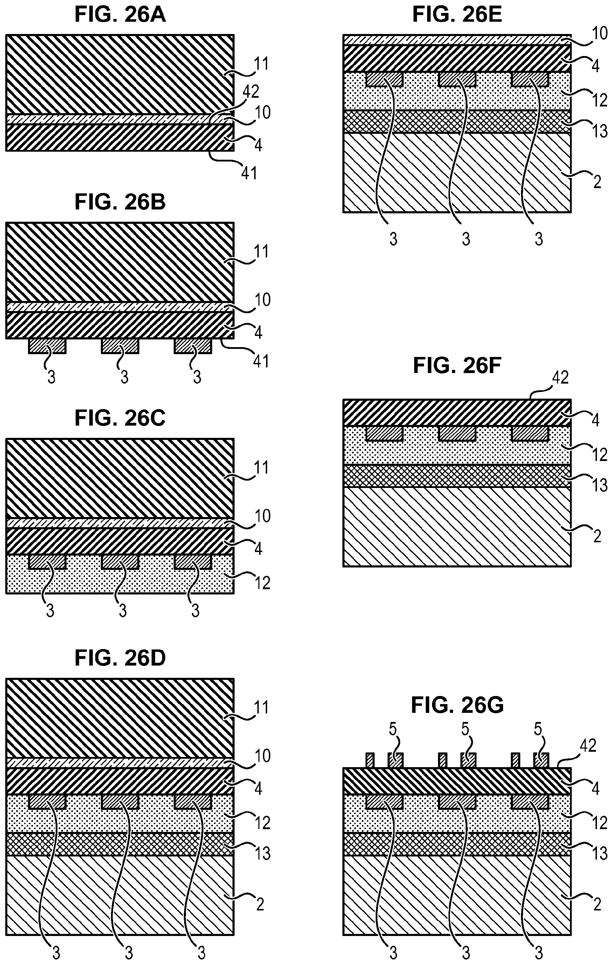

Les figures 26A à 26G illustrent de manière schématique des étapes d'un procédé de fabrication d'un dispositif résonateur conforme à l'invention.

Selon une première étape (illustrée sur la figure 26A), une couche d'arrêt 10 et une couche séparatrice 4 sont formées sur une première couche de substrat 11.

La première couche de substrat 11 est en Arséniure de gallium (GaAs) et présente une épaisseur de 300 $\mu$m.

La couche d'arrêt 10 est formée en Arséniure de gallium-aluminium (AlGaAs). La couche d'arrêt 10 s'étend entre le premier substrat 11 et la couche séparatrice 4.

La couche séparatrice 4 comprend par exemple une hétérostructure formée d'une alternance de couches GaAs - $Al_xGa_{1-x}As$ d'épaisseurs respectives 100 nm et 2$\mu$m.

Selon une deuxième étape (illustrée sur la figure 26B), une ou plusieurs première(s) piste(s) conductrice(s) 3 est(sont) formée(s) sur la première face 41 de la couche séparatrice 4.

La ou les première(s) piste(s) conductrice(s) 3 sont formées en un alliage d'or et de titane, par lithographie optique ou lithographie électronique.

Selon une troisième étape (illustrée sur la figure 26C), une couche en matériau diélectrique 12 est déposée sur la couche séparatrice 4, par exemple par dépôt chimique en phase vapeur assisté par plasma (PECVD). Le matériau diélectrique peut être du dioxyde de silicium ($SiO_2$) ou du nitrure de silicium (SiN).

Une fois la couche en matériau diélectrique 12 déposée, les premières pistes conductrices 3 se trouvent noyées dans la couche en matériau diélectrique 12.

Selon une quatrième étape (illustré sur la figure 26D), l'ensemble formé du premier substrat 11, de la couche d'arrêt 10, de la couche séparatrice 4, des premières pistes 3 et de la couche en matériau diélectrique 12, est collé sur un deuxième substrat 2.

A cet effet, la couche en matériau diélectrique 12 est revêtue d'une couche 13 d'une composition adhésive sur laquelle est rapporté le deuxième substrat 2.

La composition adhésive 13 peut être une composition à base d'époxy par exemple.

La deuxième couche de substrat 2 est formée en Arséniure de gallium (GaAs). La deuxième couche de substrat 2 est destinée à former ultérieurement le substrat 2 du ou des dispositif(s) résonateur(s).

Selon une cinquième étape (illustrée sur la figure 26E), la première couche de substrat 11 est éliminée par gravure sélective à l'acide citrique. La couche d'arrêt 10 permet de limiter la gravure pour n'éliminer que la première couche de substrat 11.

Selon une sixième étape (illustrée sur la figure 26F), la couche d'arrêt 10 est éliminée, par gravure sélective en solution aqueuse d'acide fluorhydrique..

Selon une septième étape (illustrée sur la figure 26G), une ou plusieurs deuxième(s) piste(s) conductrice(s) 5 est(sont) formée(s) sur la deuxième face 42 de la couche séparatrice 4, opposée à la première face 41.

La ou les deuxième(s) piste(s) conductrice(s) 5 sont formées en un alliage d'or et de titane, par lithographie optique ou lithographie électronique.

Le procédé permet de fabriquer collectivement un grand nombre de dispositifs résonateurs 1.

Pour les applications de ce type de structures, il est important de pouvoir optimiser le couplage de la lumière incidente avec le mode de la structure. La capacité de la structure d'interagir avec le rayonnement incident est donnée par une quantité J :

$$J = \iint E_{planaire} d^2 S$$

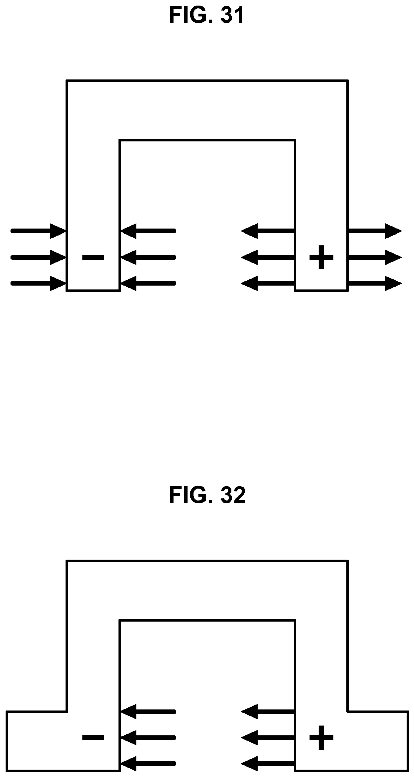

Cette quantité représente l'intégrale de la projection du champ électrique généré à la résonance électromagnétique dans le plan de la structure, du côté de l'onde électromagnétique incidente. Cette quantité peut être assimilée avec la somme des flèches (représentatives du champ $E_{planaire}$) sur les Figures 31 et 32.

A la figure 31, la somme vectorielle de toutes les flèches s'annule, et la somme J est faible.
,
En rajoutant des prolongeant les partie 5 au-delà des zones de recouvrement 51 et 52, comme à la figure 32, on minimise les composantes en contre-phase du champ $E_{planaire}$ et on augmente J.

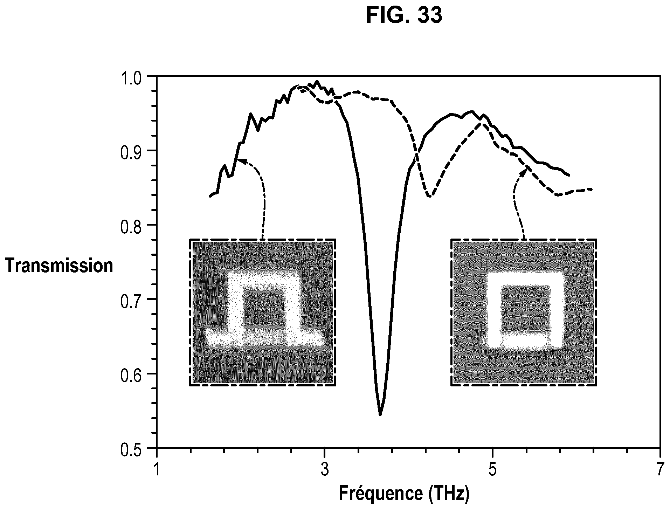

La vérification expérimentale de cet effet est donnée à la figure 33. Dans cette figure, on compare la transmission des deux structures de comme décrites dans les Figures 31 et 32. La résonance correspondante à la structure avec prolongements de la boucle 5 a une amplitude bien plus forte que la résonance de la structure sans prolongements, ce qui montre que la quantité J a été augmentée.

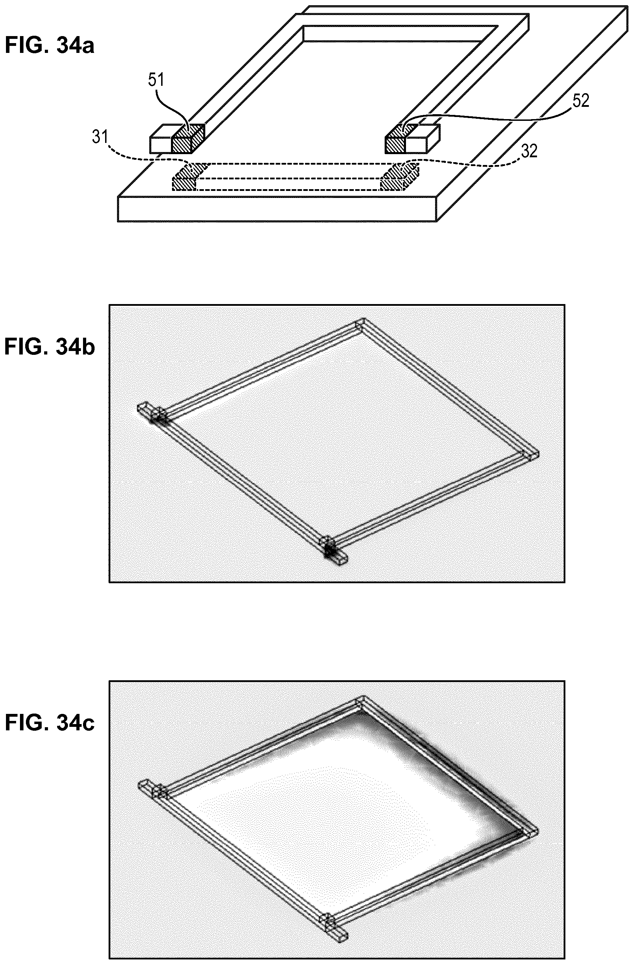

La figure 34a est un schéma d'une structure avec prolongements qui montre la disposition des deux pistes métalliques, ainsi que les zones de recouvrement 31, 32 et 51, 52.

La figure 34b est une simulation du champ électrique vertical $E_z$ d'une structure de ce type lorsque celle-ci est excitée à résonance. Ces simulations montrent que le champ est bien localisé dans les zones de recouvrement entre 31/51 et 32/52 indiquées dans 34a.

La figure 34c est une simulation du champ magnétique vertical Hz de la structure. Le champ est localisé principalement dans la boucle inductive.

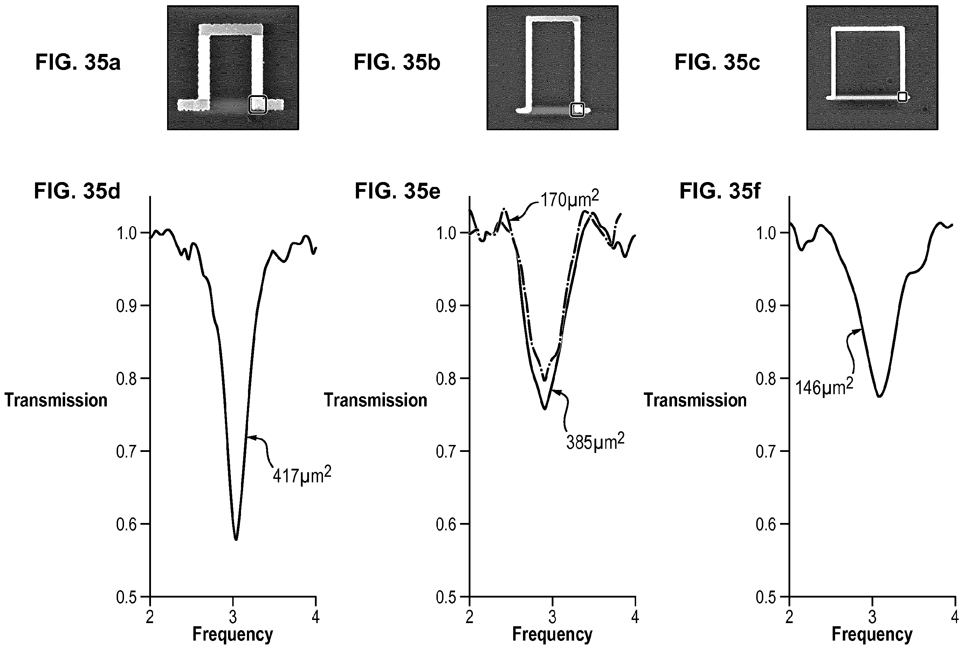

La figure 35 présente des prototypes de résonateurs avec une taille capacitive réduite. Les figures 35a 34b et 35c sont des réalisations avec des pistes métalliques ayant des dimensions respectivement W=Y=1$\mu$m (35a), W=Y=0.5$\mu$m (35b) et W=Y 0.35$\mu$m (35c). Les couches diélectrique sont en $SiO_2$ dont l'épaisseur sont respectivement T=1$\mu$m (35a), T=0.5$\mu$m (35b) et T=0.25$\mu$m (35c). Ainsi, le volume de chaque capacité indiqué par un carré sur les Figures est WxYxT=1$\mu m^3$ (34a), WxYxT =0.125$\mu m^3$ (35b) et WxYxT =0.03$\mu m^3$ (35c) .Les boucles inductives pour chaque structures sont (largeur $L_x$ x longueur $L_y$) : 4$\mu$m x 6$\mu$m (35a), 4$\mu$mx8$\mu$m (35b) ; 6$\mu$mx6$\mu$m (35c). Les spectres

de transmission d'un ensemble périodique des résonateurs identique sont montrés sur la Figure 35d pour 35a, 35e pour 35b et 35f pour 35c. Le nombre indiqué pour chaque courbe de transmission indique la surface de la cellule élémentaire pour chaque réseau des résonateurs. Les tailles des boucles inductives ont été choisis de telle manière que tous les résonateurs ont un mode à une fréquence de 3THz, avec une longueur d'onde $\lambda_{res}$=100$\mu$m. Ainsi, pour la structure de 35c, un rapport $\lambda_{res}^3$ /Vc=3,3*10^7 a été obtenu.

## Revendications

1. Dispositif résonateur électromagnétique tridimensionnel (1) de type inductance-capacité, ayant une fréquence de résonance donnée supérieure ou égale à 100 gigahertz, comprenant une première piste (3) en matériau conducteur, une deuxième piste (5) en matériau conducteur et une couche séparatrice (4), la première (3) et la deuxième piste (5) étant formées respectivement de part et d'autre de la couche séparatrice (4) qui est une hétérostructure quantique agencée entre la première piste (3) et la deuxième piste (5),
la première piste (3) étant finie et présentant une partie intermédiaire (33) reliant deux parties de chevauchement (31, 32), et la deuxième piste (5) étant finie et présentant une boucle inductive (53) ouverte avec deux branches longitudinales (55, 56) reliant deux parties de chevauchement (51, 52), chaque partie de chevauchement (31, 32) de la première piste (3) étant disposée en regard d'une partie de chevauchement respective (51, 53) de la deuxième piste (5) de manière à former deux capacités ($C_1$, $C_2$), espacées spatialement l'une de l'autre, la boucle inductive (53) étant propre à générer un champ magnétique (H) à l'intérieur de la boucle inductive et autour des pistes, et chaque capacité étant propre à générer un champ électrique (E) à l'intérieur de la couche séparatrice (4) lorsque le dispositif est excité à la fréquence de résonance; **caractérisé en ce que** la première et la deuxième piste (3, 5) sont disposées de façon à que le champ électrique (E) généré par la deuxième capacité ($C_2$) soit de signe opposé au champ électrique (E) généré par la première capacité ($C_1$) et à que le champ électrique (E) soit confiné dans les parties de chevauchement (31, 32, 51, 52), lorsque le dispositif est excité à la fréquence de résonance.

2. Dispositif selon la revendication 1, dans lequel le champ magnétique (H) généré par la boucle inductive (53) dans la couche séparatrice (4) présente une composante principale s'étendant selon une direction parallèle au champ électrique (E) généré par les capacités.

3. Dispositif selon l'une des revendications 1 et 2, dans lequel le champ électrique (E) généré par chaque capacité s'étend selon une direction parallèle à la direction (z) de l'épaisseur de la couche séparatrice (4).

4. Dispositif selon l'une des revendications 1 à 3, dans lequel au moins 70% de l'énergie électrique générée par le champ électrique (E) est localisée dans des zones de la couche séparatrice (4) située entre les parties de chevauchement (31, 51 ; 32, 52) de la première piste (3) et de la deuxième piste (5).

5. Dispositif selon l'une des revendications 1 à 4, dans lequel les parties de chevauchement (51, 52) de la deuxième piste (5) sont espacées l'une de l'autre d'une distance d'espacement, $L_x$, la boucle inductive (53) présente une dimension longitudinale, $L_y$, chaque partie de chevauchement présente une longueur, W, et une largeur, Y, et dans lequel Lx+2Y et Ly+W+Y sont inférieures à la longueur d'onde de la résonance $\lambda$ défini comme étant égale à c/ $f_{res}$, où c est la vitesse de la lumière dans le vide et $f_{res}$ est la fréquence de résonance du dispositif.

6. Dispositif selon l'une des revendications 1 à 5, dans lequel la couche séparatrice présente une épaisseur de T inférieure à $\lambda/2n$, où $n$ est l'indice de réfraction de la couche séparatrice (4) et $\lambda$ est la longueur d'onde de résonance, $\lambda$ étant égale à c/$f_{res}$, où c est la vitesse de la lumière dans le vide et $f_{res}$ est la fréquence de résonance du dispositif.

7. Dispositif selon l'une des revendications 1 à 6, dans lequel les branches longitudinales de l'une des pistes présentent des prolongements latéraux.

8. Dispositif selon l'une des revendications 1 à 7, dans lequel chaque zone de la couche séparatrice (4) située entre une partie de chevauchement (31, 32) de la première piste (3) et une partie de chevauchement (51, 52) de la deuxième piste (5) formant une capacité présente un volume inférieur ou égal à $(\lambda/2n)^3$, où $n$ est l'indice de réfraction de la couche séparatrice (4) et $\lambda$ est la longueur d'onde de résonance, $\lambda$ étant égale à c/$f_{res}$, où c est la vitesse de la lumière dans le vide et $f_{res}$ est la fréquence de résonance du dispositif.

9. Dispositif selon l'une des revendications 1 à 8, dans lequel la première piste conductrice (3) présente une forme rectiligne.

**10.** Dispositif selon l'une des revendications 1 à 9, dans lequel les dimensions et le positionnement des capacités ($C_1$, $C_2$) et ceux de la boucle inductive (53) permettent de séparer spatialement à la fréquence de résonance ($f_{res}$), suivant un plan médian (x, y) de la couche séparatrice (4), perpendiculairement à une direction de l'épaisseur (z) de la couche séparatrice (4), des composantes principales des champs électriques (E) et du champ magnétique (H) s'étendant selon la direction de l'épaisseur (z).

**11.** Dispositif selon l'une des revendications 1 à 10, dans lequel la deuxième piste conductrice (5) présente une forme de U ayant deux branches parallèles (55, 56), les parties de chevauchement (51, 52) étant situées aux extrémités respectives des branches du U.

**12.** Dispositif selon l'une des revendications 1 à 11, dans lequel la deuxième piste (5) présente une forme asymétrique.

**13.** Dispositif selon l'une des revendications 1 à 12, dans lequel le dispositif comprend au moins une troisième piste agencée avec les première et deuxième pistes pour présenter un nombre pair p de capacités avec p supérieur ou égal à 4.

**14.** Dispositif selon l'une des revendications 1 à 13, comprenant un motif métallique (6, 7, 8) couplé de manière capacitive ou inductive avec la deuxième piste conductrice (5), le motif métallique (6, 7, 8) étant propre à collecter un rayonnement électromagnétique (R) éclairant le dispositif.

**15.** Ensemble résonateur électrique, comprenant une pluralité de dispositifs (1) selon l'une des revendications 1 à 14, un premier conducteur électrique raccordant électriquement les premières pistes (3) entre elles et un deuxième conducteur électrique raccordant les deuxième pistes (5) entre elles.

**Patentansprüche**

**1.** Dreidimensionale elektromagnetische Resonatorvorrichtung (1) vom Typ Induktanz-Kapazität mit einer gegebenen Resonanzfrequenz größer oder gleich 100 Gigahertz, umfassend eine erste Bahn (3) aus leitendem Material, eine zweite Bahn (5) aus leitendem Material und eine Trennschicht (4), wobei die erste (3) und die zweite Bahn (5) jeweils auf beiden Seiten der Trennschicht (4) ausgebildet sind, die eine Quantum-Heterostruktur ist, die zwischen der ersten Bahn (3) und der zweiten Bahn (5) angeordnet ist,
wobei die erste Bahn (3) endlich ist und einen Übergangsteil (33) aufweist, der zwei Überlappungsteile (31, 32) verbindet, und die zweite Bahn (5) endlich ist und eine offene induktive Schleife (53) mit zwei länglichen Schenkeln (55, 56) aufweist, die zwei Überlappungsteile (51, 52) verbindet, wobei jeder Überlappungsteil (31, 32) der ersten Bahn (3) gegenüber einem jeweiligen Überlappungsteil (51, 53) der zweiten Bahn (5) derart angeordnet ist, dass zwei voneinander räumlich getrennte Kapazitäten ($C_1$, $C_2$) gebildet werden, wobei die induktive Schleife (53) imstande ist, ein Magnetfeld (H) im Inneren der induktiven Schleife und um Bahnen zu erzeugen, und jede Kapazität imstande ist, ein elektrisches Feld (E) im Inneren der Trennschicht (4) zu erzeugen, wenn die Vorrichtung in der Resonanzfrequenz erregt ist,
**dadurch gekennzeichnet, dass** die erste und die zweite Bahn (3, 5) derart angeordnet sind, dass das von der zweiten Kapazität ($C_2$) erzeugte elektrische Feld (E) umgekehrten Vorzeichens zu dem von der ersten Kapazität ($C_1$) erzeugten elektrischen Feld (E) ist und dass das elektrische Feld (E) in den Überlappungsteilen (31, 32, 51, 52) eingeschlossen ist, wenn die Vorrichtung in der Resonanzfrequenz erregt ist.

**2.** Vorrichtung nach Anspruch 1, wobei das von der induktiven Schleife (53) in der Trennschicht (4) erzeugte Magnetfeld (H) eine Hauptkomponente aufweist, die sich gemäß einer Richtung erstreckt, die parallel zu dem von den Kapazitäten erzeugten elektrischen Feld (E) ist.

**3.** Vorrichtung nach einem der Ansprüche 1 und 2, wobei sich das von jeder Kapazität erzeugte elektrische Feld (E) gemäß einer Richtung erstreckt, die parallel zu der Richtung (z) der Stärke der Trennschicht (4) ist.

**4.** Vorrichtung nach einem der Ansprüche 1 bis 3, wobei mindestens 70 % der von dem elektrischen Feld (E) erzeugten Energie in Zonen der Trennschicht (4) lokalisiert ist, die sich zwischen den Überlappungsteilen (31, 51; 32, 52) der ersten Bahn (3) und der zweiten Bahn (5) befindet.

**5.** Vorrichtung nach einem der Ansprüche 1 bis 4, wobei die Überlappungsteile (51, 52) der zweiten Bahn (5) voneinander in einem Beabstandungsabstand $L_x$ beabstandet sind, die induktive Schleife (53) ein Längsmaß $L_y$ aufweist, jedes Überlappungsteil eine Länge W und eine Breite Y aufweist, und wobei Lx+2Y und Ly+W+Y kleiner als die Wellenlänge der Resonanz $\lambda$ sind, definiert als gleich $c/f_{res}$, wobei $c$ die Geschwindigkeit des Lichts im Vakuum ist und $f_{res}$ die Resonanzfrequenz der Vorrichtung ist.

6. Vorrichtung nach einem der Ansprüche 1 bis 5, wobei die Trennschicht eine Stärke T kleiner als $\lambda/2n$ aufweist, wobei $n$ der Refraktionsindex der Trennschicht (4) ist und $\lambda$ die Resonanzwellenlänge ist, wobei $\lambda$ gleich $c/f_{res}$ ist, wobei $c$ die Geschwindigkeit des Lichts im Vakuum ist und $f_{res}$ die Resonanzfrequenz der Vorrichtung ist.

7. Vorrichtung nach einem der Ansprüche 1 bis 6, wobei die länglichen Schenkel von einer der Bahnen seitliche Verlängerungen aufweisen.

8. Vorrichtung nach einem der Ansprüche 1 bis 7, wobei jede Zone der Trennschicht (4), die sich zwischen einem Überlappungsteil (31, 32) der ersten Bahn (3) und einem Überlappungsteil (51, 52) der zweiten Bahn (5) befindet, eine Kapazität bildend, ein Volumen kleiner oder gleich $(\lambda/2n)^3$ aufweist, wobei $n$ der Refraktionsindex der Trennschicht (4) ist und $\lambda$ die Resonanzwellenlänge ist, wobei $\lambda$ gleich $c/f_{res}$ ist, wobei $c$ die Geschwindigkeit des Lichts im Vakuum ist und $f_{res}$ die Resonanzfrequenz der Vorrichtung ist.

9. Vorrichtung nach einem der Ansprüche 1 bis 8, wobei die erste Leitungsbahn (3) eine gerade Form aufweist.

10. Vorrichtung nach einem der Ansprüche 1 bis 9, wobei die Maße und die Positionierung der Kapazitäten ($C_1$, $C_2$) und die der induktiven Schleife (53) erlauben, räumlich in Resonanzfrequenz ($f_{res}$) zu trennen, gemäß einer Mittelebene (x, y) der Trennschicht (4), senkrecht zu einer Richtung der Stärke (z) der Trennschicht (5), Hauptkomponenten der elektrischen Felder (E) und des Magnetfelds (H), die sich gemäß der Richtung der Stärke (z) erstrecken.

11. Vorrichtung nach einem der Ansprüche 1 bis 10, wobei die zweite Leitungsbahn (5) eine U-Form mit zwei parallelen Schenkeln (55, 56) aufweist, wobei sich die Überlappungsteile (51, 52) an den jeweiligen Enden der Schenkel des U befinden.

12. Vorrichtung nach einem der Ansprüche 1 bis 11, wobei die zweite Bahn (5) eine asymmetrische Form aufweist.

13. Vorrichtung nach einem der Ansprüche 1 bis 12, wobei die Vorrichtung mindestens eine dritte Bahn aufweist, die mit der ersten und zweiten Bahn ausgebildet ist, um eine gerade Anzahl p von Kapazitäten mit p größer oder gleich 4 darzustellen.

14. Vorrichtung nach einem der Ansprüche 1 bis 13, umfassend ein Metallmotiv (6, 7, 8), das kapazitiv oder induktiv mit der zweiten Leitungsbahn (5) gekoppelt ist, wobei das Metallmotiv (6, 7, 8) imstande ist, eine elektromagnetische Strahlung (R) zu sammeln, welche die Vorrichtung beleuchtet.

15. Elektrische Resonatoreinheit, umfassend eine Vielzahl von Vorrichtungen (1) nach einem der Ansprüche 1 bis 14, wobei ein erster elektrischer Leiter die ersten Bahnen (3) miteinander elektrisch verbindet und ein zweiter elektrischer Leiter die zweiten Bahnen (5) miteinander elektrisch verbindet.

## Claims

1. A three-dimensional electromagnetic resonator device (1) of inductance-capacitance type, having a given resonant frequency greater than or equal to 100 gigahertz, comprising a first track (3) made of conductive material, a second track (5) made of conductive material and a separating layer (4), the first (3) and second (5) tracks being formed respectively on either side of the separating layer (4) which is a quantum heterostructure arranged between the first track (3) and the second track (5),
the first track (3) being finished and having an intermediate part (33) connecting two overlapping parts (31, 32), and the second track (5) being finished and having an open inductive loop (53) with two longitudinal branches (55, 56) connecting two overlapping parts (51, 52), each overlapping part (31, 32) of the first track (3) being positioned facing a respective overlapping part (51, 53) of the second track (5) so as to form two capacitances ($C_1$, $C_2$), spaced apart spatially from each other, the inductive loop (53) being suitable for generating a magnetic field (H) inside the inductive loop and around the tracks, and each capacitance being suitable for generating an electrical field (E) inside the separating layer (4) when the device is excited at the resonant frequency;
**characterised in that** the first and the second tracks (3, 5) are positioned such that the electrical field (E) generated by the second capacitance ($C_2$) is of opposite sign to the electrical field (E) generated by the first capacitance ($C_1$) and such that the electrical field (E) is confined in the overlapping parts (31, 32, 51, 52) when the device is excited at the resonant frequency.

2. The device according to claim 1, wherein the magnetic field (H) generated by the inductive loop (53) in the separating layer (4) has a main component extending in a direction parallel to the electrical field (E) generated by the capacitances.

3. The device according to one of claims 1 and 2, wherein the electrical field (E) generated by each capacitance extends in a direction parallel to the direction (z) of the thickness of the separating layer (4) .

4. The device according to one of claims 1 to 3, wherein at least 70% of the electrical energy generated by the electrical field (E) is located in zones of the separating layer (4) located between the overlapping parts (31, 51; 32, 52) of the first track (3) and of the second track (5).

5. The device according to one of claims 1 to 4, wherein the overlapping parts (51, 52) of the second track (5) are spaced apart from each other by a spacing distance, $L_x$, the inductive loop (53) has a longitudinal dimension, $L_y$, each overlapping part has a length, W, and a width, Y, and wherein $L_x+2Y$ and $L_y+W+Y$ are less than the wavelength of the resonance $\lambda$ defined as being equal to $c/f_{res}$, where $c$ is the speed of light in the vacuum and $f_{res}$ is the resonant frequency of the device.

6. The device according to one of claims 1 to 5, wherein the separating layer has a thickness of T less than $\lambda/2n$, where $n$ is the refraction index of the separating layer (4) and $\lambda$ is the resonance wavelength, $\lambda$ being equal to $c/f_{res}$, where $c$ is the speed of light in the vacuum and $f_{res}$ is the resonant frequency of the device.

7. The device according to one of claims 1 to 6, wherein the longitudinal branches of one of the tracks have lateral extensions.

8. The device according to one of claims 1 to 7, wherein each zone of the separating layer (4) located between an overlapping part (31, 32) of the first track (3) and an overlapping part (51, 52) of the second track (5) forming a capacitance has a volume less than or equal to $(\lambda/2n)^3$, where $n$ is the refraction index of the separating layer (4) and $\lambda$ is the resonance wavelength, $\lambda$ being equal to $c/f_{res}$, where c is the speed of light in the vacuum and $f_{res}$ is the resonant frequency of the device.

9. The device according to one of claims 1 to 8, wherein the first conductive track (3) has a rectilinear form.

10. The device according to one of claims 1 to 9, wherein the dimensions and the positioning of the capacitances ($C_1$, $C_2$) and those of the inductive loop (53) separate spatially at the resonant frequency ($f_{res}$), along a median plane (x, y) of the separating layer (4), perpendicularly to a direction of the thickness (z) of the separating layer (4), main components of the electrical fields (E) and of the magnetic field (H) extending along the direction of the thickness (z).

11. The device according to one of claims 1 to 10, wherein the second conductive track (5) has a U-shape having two parallel branches (55, 56), the overlapping parts (51, 52) being located at the respective ends of the U-shaped branches.

12. The device according to one of claims 1 to 11, wherein the second track (5) has an asymmetrical form.

13. The device according to one of claims 1 to 12, wherein the device comprises at least a third track arranged with the first and second tracks to present a number pair p of capacitances with p greater than or equal to 4.

14. The device according to one of claims 1 to 13, comprising a metallic pattern (6, 7, 8) coupled capacitively or inductively with the second conductive track (5), the metallic pattern (6, 7, 8) being suitable for collecting electromagnetic radiation (R) lighting the device.

15. An electrical resonator assembly, comprising a plurality of devices (1) according to one of claims 1 to 14, a first electrical conductor electrically connecting the first tracks (3) together and a second electrical conductor connecting the second tracks (5) together.

## FIG. 1

## FIG. 2

**FIG. 3**

FIG. 5

FIG. 4

## FIG. 6

## FIG. 7

## FIG. 8A

## FIG. 8B

## FIG. 8C

# FIG. 9

Frequency (THz) vs Scale parameter $1/\sqrt{WL_xL_y}$ $\mu m^{-3/2}$

EP 3 262 707 B1

**FIG. 10**

Frequency (THz)

422
444
488

224
244
264
284

262
282
242
222

- - - - 3D FTD model
——— Equiv. LC circuit (b)

Scale parameter p μm⁻³/²

**FIG. 11A**

E
54
A
55
B
56
D
51
33
52

**FIG. 11B**

51
C_fringe
52
4
C
C
3

**FIG. 11C**

L_E
M_AB
L_A
M_ED
C_fringe
C
C
L_D

## FIG. 12

## FIG. 13

## FIG. 14

## FIG. 15

**FIG. 26A**

**FIG. 26E**

**FIG. 26B**

**FIG. 26C**

**FIG. 26F**

**FIG. 26D**

**FIG. 26G**

# FIG. 16

FIG. 17
FIG. 18
FIG. 19
FIG. 20
FIG. 21
FIG. 22
FIG. 23
FIG. 24
FIG. 25

# FIG. 27

$L_x = 3.5\,\mu m$

$\underline{E_2}$

$L_y = 2.85\,\mu m$

$W = 1\,\mu m$

$Y = 1\,\mu m$

$2.7 \times 10^7$

(V/m)

0

$-2.7 \times 10^7$

$f_{res} = 4.17\,THz$     $\lambda_{res} = 72\,\mu m$

# FIG. 28

$\underline{H_2}$

$3.7 \times 10^4$

(A/m)

0

$-3.7 \times 10^4$

$f_{res} = 4.17\,THz$     $\lambda_{res} = 72\,\mu m$

29

## FIG. 29

$L_x = 5.54\mu m$

$L_y = 4.05\mu m$

$E_2$

$B$

$W = 0,5\mu m$

$Y = 0,2\mu m$

$3 \times 10^7$

0

$-3 \times 10^7$

(V/m)

C
B
A

$f_{res} = 4.61$ THz — A          C — $\lambda_{res} = 65\mu m$

## FIG. 30

C     A

$H_2$

$B$

$2.4 \times 10^4$

0

$-2.4 \times 10^4$

(A/m)

C
B
A

$f_{res} = 4.61$ THz          $\lambda_{res} = 65\mu m$

**FIG. 31**

**FIG. 32**

FIG. 33

**FIG. 34a**

**FIG. 34b**

**FIG. 34c**

FIG. 35a

FIG. 35b

FIG. 35c

FIG. 35d

Transmission

417µm²

FIG. 35e

Transmission

170µm²

385µm²

FIG. 35f

Transmission

146µm²

Frequency

Frequency

Frequency

EP 3 262 707 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2007273832 B
- WO 2014072335 A
- US 2008296710 A

**Littérature non-brevet citée dans la description**

- **B. PAULILLO et al.** Circuit-tunable sub-wavelength THz resonators : hybridizing optical cavities and loop antennas. *Optics Express,* 08 Septembre 2014, vol. 22 (18
- **HOER, C. ; C. LOVE.** Exact inductance equations for rectangular conductors with application to more complicated geometries. *J. Res. NBS,* 1965, vol. 69C (2), 127-137
- **H. B. PALMER.** Capacitance of a parallel-plate capacitor by the Schwartz-Christoffel transformation. *Trans. AIEE,* Mars 1927, vol. 56, 363
- Inder Bahl, Lumped Elements for RF and Microwave Circuits. ARTECH HOUSE, INC, 2003, 458